# EUROPEAN PATENT APPLICATION

(11) **EP 4 772 959 A1**
(43) Date of publication of application: **08.07.2026**
(21) Application number: 24860301.1
(22) Date of filing: 21.08.2024
(51) Int. Cl.: G06F 1/16, G06F 1/18, H05K 1/02

(54) **ELECTRONIC DEVICE INCLUDING FLEXIBLE DISPLAY AND ANTENNA**

(30) Priority: 01.09.2023 KR 20230116563; 23.10.2023 KR 20230142504
(71) Applicant: Samsung Electronics Co., Ltd., Suwon-si, Gyeonggi-do 16677 (KR)
(72) Inventor: PARK, Sungkoo, Suwon-si, Gyeonggi-do 16677 (KR); KIM, Seunghwan, Suwon-si, Gyeonggi-do 16677 (KR); CHUN, Jaebong, Suwon-si, Gyeonggi-do 16677 (KR); NAM, Hojung, Suwon-si, Gyeonggi-do 16677 (KR); LEE, Kyungjae, Suwon-si, Gyeonggi-do 16677 (KR); LEE, Kookjoo, Suwon-si, Gyeonggi-do 16677 (KR); HWANG, Soonho, Suwon-si, Gyeonggi-do 16677 (KR)
(74) Representative: HGF
(86) International application number: PCT/KR2024/012457
(87) International publication number: WO 2025/048381

(57) **Abstract**

This electronic device comprises: a wireless communication circuit; a housing including a first housing part and a second housing part; and a flexible display including an active area and a non-active area, and including a plurality of layers including conductive sheets, wherein the conductive sheets include a conductive sheet including a first portion positioned in the active area and a second portion positioned in the non-active area. The second portion includes at least one power feeding point electrically connected to the wireless communication circuit and at least one ground point electrically connected to a ground of the electronic device. The wireless communication circuit is configured to communicate with an external electronic device by using at least a portion of the second portion.

## Description

### [Technical Field]

The present disclosure relates to an electronic device including a flexible display and an antenna.

### [Background Art]

An electronic device including a display with a large screen may increase usability of a user. As demand for an electronic device having high portability increases, the electronic device may include a deformable flexible display. The deformable flexible display may be slidably deformable or be foldably deformable. A part of the flexible display may be positioned within a housing, and may not be exposed to the outside.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device is provided. The electronic device may comprise wireless communication circuitry. The electronic device may comprise a first housing part and a second housing part movably connected to the first housing part. The electronic device may include a flexible display including an active area configured to display visual information and a non-active area positioned within the housing independently of movement of the second housing part. The flexible display may include a plurality of layers including a conductive sheet. The conductive sheet may include a first part positioned within the active area and a second part positioned within the non-active area. The second part may include at least one feed point electrically connected to the wireless communication circuitry and at least one ground point electrically connected to a ground of the electronic device. The wireless communication circuitry may be configured to communicate with an external electronic device by using at least a portion of the second part.

An electronic device is provided. The electronic device may comprise wireless communication circuitry. The electronic device may comprise a first housing part and a second housing part movably connected to the first housing part. The electronic device may include a flexible display including an active area configured to display visual information and a non-active area positioned within the housing independently of movement of the second housing part. The flexible display may include a conductive sheet including at least one of an electrostatic discharge sheet, a support sheet, or a shielding sheet for shielding noise. The conductive sheet may include a first part positioned within the active area and a second part positioned within the non-active area. The second part may include at least one ground point electrically connected to a ground of the electronic device and at least one feed point positioned closer to an end of the second part spaced apart from the first part than the ground point and electrically connected to the wireless communication circuitry. The wireless communication circuitry may be configured to communicate with an external electronic device by using at least a portion of the second part.

### [Description of the Drawings]

FIG. 1 is a block diagram of an electronic device in a network environment according to various embodiments.
FIG. 2A is a top plan view of an electronic device according to an embodiment in a first state.
FIG. 2B is a bottom view of an electronic device according to an embodiment in a first state.
FIG. 2C is a top plan view of an electronic device according to an embodiment in a second state.
FIG. 2D is a bottom view of an electronic device according to an embodiment in a second state.
FIGS. 3A and 3B are exploded perspective views of an electronic device according to an embodiment.
FIG. 4A is a cross-sectional view of an electronic device according to an embodiment in a first state.
FIG. 4B is a cross-sectional view of an electronic device according to an embodiment in a second state.
FIG. 5A illustrates a front surface of an electronic device according to an embodiment.
FIG. 5B illustrates a rear surface and an inside of an electronic device according to an embodiment when the electronic device is in a first state.
FIG. 5C illustrates a rear surface and an inside of an electronic device according to an embodiment when the electronic device is in a second state.
FIG. 5D is a block diagram of an electronic device according to an embodiment.
FIG. 6A illustrates a rear surface of an electronic device according to an embodiment.
FIG. 6B schematically illustrates an electromagnetic field and a radiation pattern formed when a part of an exemplary conductive sheet operates as an antenna radiator.
FIG. 6C schematically illustrates an electromagnetic field and a radiation pattern formed when another part of an exemplary conductive sheet operates as an antenna radiator.
FIG. 7A illustrates a rear surface of an electronic device according to an embodiment.
FIG. 7B is a graph showing an S-parameter of an antenna in a first state or a second state of the electronic device illustrated in FIG. 7A.
FIG. 8A illustrates a printed circuit board and a connection structure of an electronic device according to an embodiment.
FIG. 8B illustrates a printed circuit board and a connection structure according to a state of an electronic device according to an embodiment.
FIG. 9A illustrates a printed circuit board and a connection structure of an electronic device according to an embodiment.
FIG. 9B is a graph showing an S-parameter of an antenna of the electronic device illustrated in FIG. 9A.
FIG. 9C is a graph showing an efficiency of an antenna of the electronic device illustrated in FIG. 9A.
FIG. 10A illustrates a rear surface of an exemplary electronic device.
FIG. 10B is a graph for comparing a reflection coefficient of an antenna of the electronic device illustrated in FIG. 9A and a reflection coefficient of an antenna of the electronic device illustrated in FIG. 10A.
FIG. 11 illustrates a printed circuit board and a connection structure of an electronic device according to an embodiment.
FIG. 12A illustrates a front surface of an electronic device according to an embodiment.
FIG. 12B illustrates a rear surface of an electronic device according to an embodiment.
FIG. 13A illustrates an electronic device according to an embodiment.
FIG. 13B schematically illustrates a flexible display and a printed circuit board of the electronic device illustrated in FIG. 13A.

### [Mode for Invention]

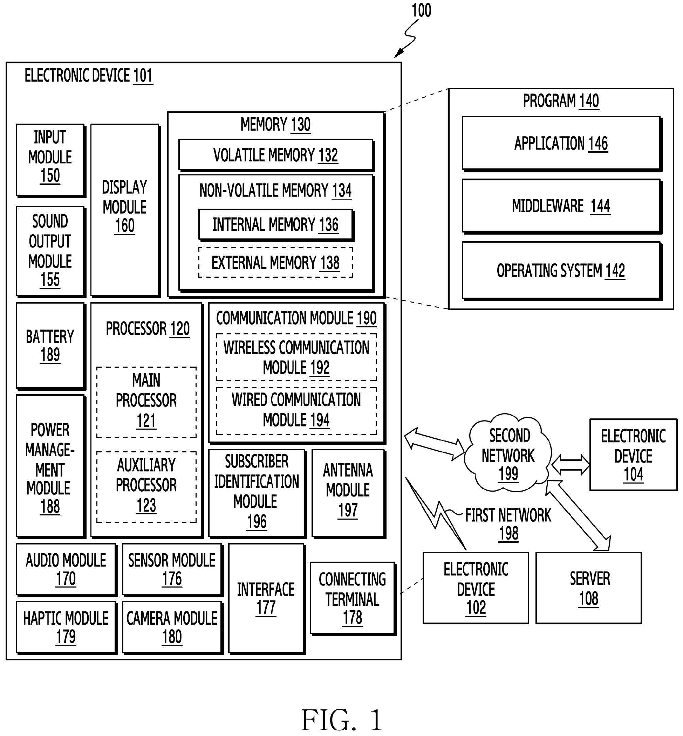

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

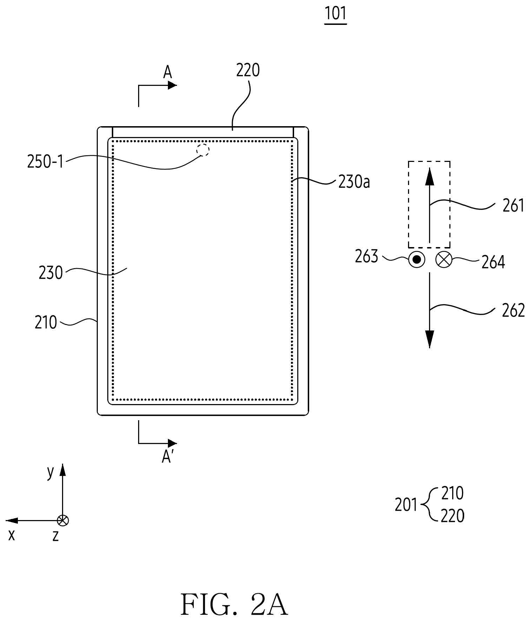

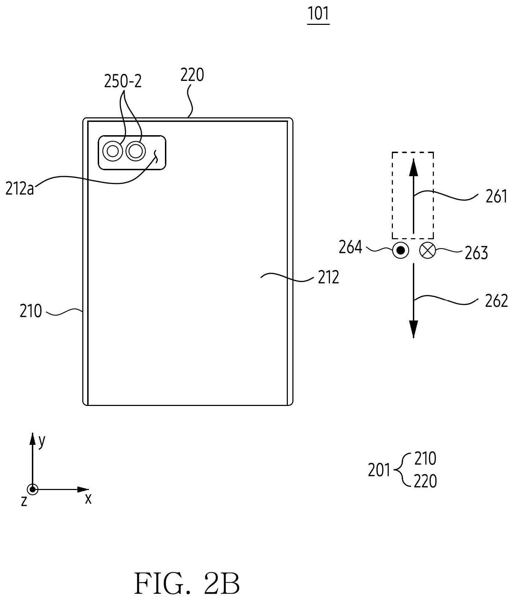

For example, a display of the display module 160 may be flexible. For example, the display may include a display area exposed outside a housing of the electronic device 101 providing at least a portion of an outer surface of the electronic device 101. For example, since the display has flexibility, at least a portion of the display may be rollable into the housing or slidable into the housing. For example, a size of the display area may be changed according to a size of the at least a portion of the display rolled into the housing or slid into the housing. For example, the electronic device 101 including the display may be in a plurality of states including a first state providing the display area having a first size and a second state providing the display area having a second size different from the first size. For example, the first state may be exemplified through descriptions of FIGS. 2A and 2B.

FIG. 2A is a top plan view of an electronic device according to an embodiment in a first state.

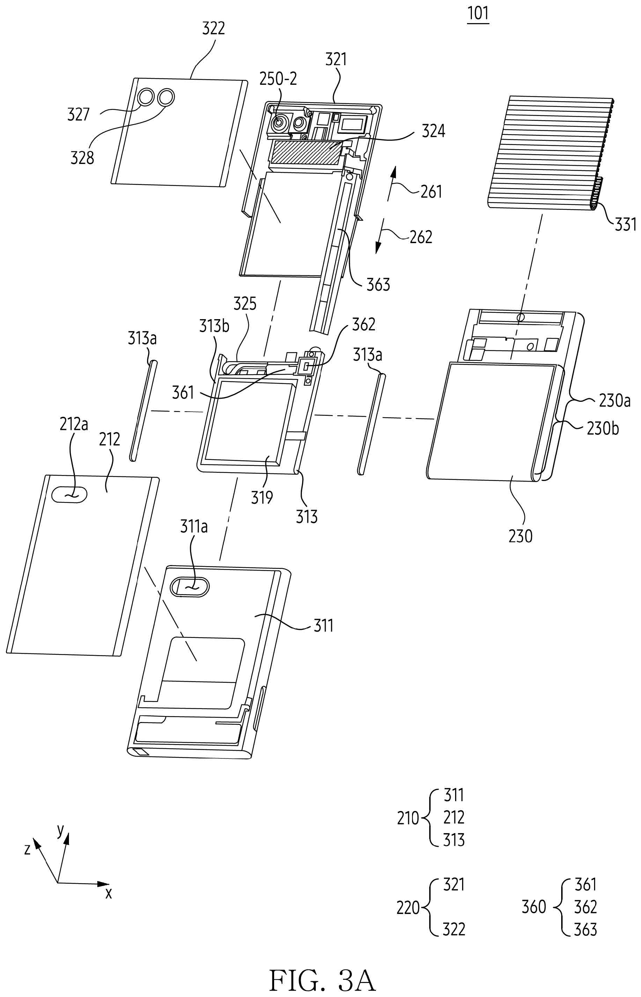

Referring to FIG. 2A, an electronic device 101 may include a housing 201 and a display 230 (e.g., the display). For example, the housing 201 may include a first housing part 210 and a second housing part 220. For example, the first housing part 210 may be movable with respect to the second housing part 220 in a first direction 261 parallel to a y-axis or in a second direction 262 parallel to the y-axis and opposite to the first direction 261. In the present disclosure, although it is described that the first housing part 210 is moved with respect to the second housing part 220, the present disclosure is not limited thereto. For example, the housing 201 may have a structure in which an overall size of the housing 201 may be changed according to a change in a relative positional relationship between the first housing part 210 and the second housing part 220. For example, by an operation of a motor (e.g., a motor 361 of FIG. 3A) to be described later, the relative positional relationship between the first housing part 210 and the second housing part 220 may be changed. For example, by the motor 361, the second housing part 220 may be movable with respect to the first housing part 210, or both the first housing part 210 and the second housing part 220 may be movable.

The electronic device 101 may be in the first state. For example, in the first state, the second housing part 220 may be movable with respect to the first housing part 210 in the first direction 261 among the first direction 261 and the second direction 262. For example, in the first state, the second housing part 220 may not be substantially movable with respect to the first housing part 210 in the second direction 262.

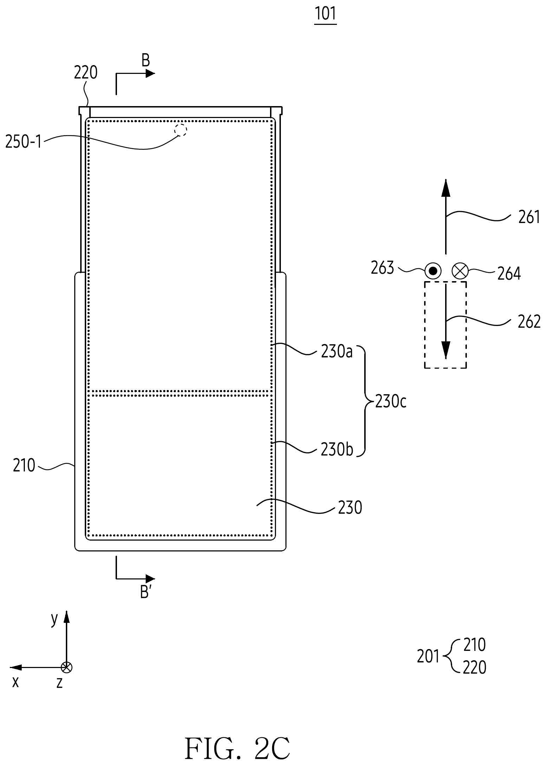

In the first state, the display 230 may provide the display area having a smallest size. For example, in the first state, the display area may correspond to a first display area 230a. For example, although not illustrated in FIG. 2A, in the first state, a second display area (e.g., the second display area 230b of FIG. 2C) of the display 230 different from the first display area 230a which is the display area may be included in the first housing part 210. For example, in the first state, the area (e.g., the second display area 230b of FIG. 2C) may be covered by the first housing part 210. For example, in the first state, the area may be rollable into the first housing part 210. For example, in the first state, the first display area 230a may include a planar portion. However, it is not limited thereto. For example, the first display area 230a may include a curved portion extending from the planar portion and positioned in an edge portion in the first state.

The first state may be referred to as a slide-in state or a closed state, in terms of at least a portion of the second housing part 220 being positioned within the first housing part 210. For example, the first state may be referred to as a reduced state, in terms of providing the display area having a smallest size. However, it is not limited thereto.

The second housing part 220 may include a first image sensor 250-1 in a camera module 180, exposed through a part of the first display area 230a and facing a third direction 263 parallel to a z-axis. For example, although not illustrated in FIG. 2A, the second housing part 220 may include one or more second image sensors in the camera module 180, exposed through a part of the second housing part 220 and facing a fourth direction 264 parallel to the z-axis and opposite to the third direction 263. For example, the one or more second image sensors may be exemplified through a description of FIG. 2B.

FIG. 2B is a bottom view of an electronic device according to an embodiment in a first state.

Referring to FIG. 2B, in the first state, one or more second image sensors 250-2 disposed in the second housing part 220 may be positioned within a structure disposed in the first housing part 210 for the one or more second image sensors 250-2. For example, light from outside of the electronic device 101 may be received by the one or more second image sensors 250-2 through the structure, in the first state. For example, since the one or more second image sensors 250-2 are positioned within the structure in the first state, the one or more second image sensors 250-2 may be exposed through the structure in the first state. The structure may be implemented variously. For example, the structure may be an opening or a notch. For example, the structure may be an opening 212a in a first plate 212 of the first housing part 210 surrounding at least a portion of the second housing part 220. However, it is not limited thereto. For example, in the first state, the one or more second image sensors 250-2 included in the second housing part 220 may be covered by the first plate 212 of the first housing part 210.

The first state may be changed to the second state.

The first state (or the second state) may be changed to the second state (or the first state) through intermediate states between the first state and the second state.

The first state (or the second state) may be changed to the second state (or the first state) based on a user input. For example, the first state (or the second state) may be changed to the second state (or the first state) in response to a user input for a physical button exposed through a part of the first housing part 210 or a part of the second housing part 220. For example, the first state (or the second state) may be changed to the second state (or the first state) in response to a touch input for an executable object displayed in the display area. For example, the first state (or the second state) may be changed to the second state (or the first state) in response to a touch input having a contact point on the display area and having a pressing strength greater than or equal to a reference strength. For example, the first state (or the second state) may be changed to the second state (or the first state) in response to a voice input received through a microphone of the electronic device 101. For example, the first state (or the second state) may be changed to the second state (or the first state) in response to an external force applied to the first housing part 210 and/or the second housing part 220 to move the second housing part 220 with respect to the first housing part 210. For example, the first state (or the second state) may be changed to the second state (or the first state) in response to a user input identified in an external electronic device (e.g., earbuds or smart watch) connected to the electronic device 101. However, it is not limited thereto.

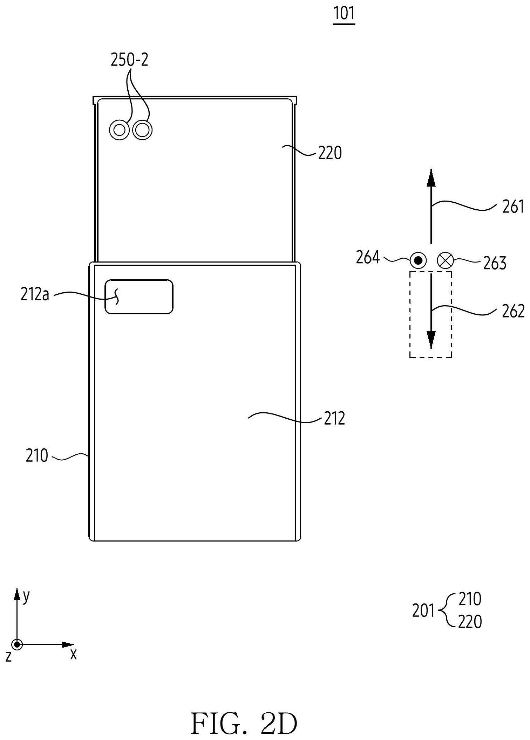

The second state may be exemplified through descriptions of FIG. 2C and FIG. 2D.

FIG. 2C is a top plan view of an electronic device according to an embodiment in a second state.

Referring to FIG. 2C, the electronic device 101 may be in the second state. For example, in the second state, the second housing part 220 may be movable with respect to the first housing part 210 in the second direction 262 among the first direction 261 and the second direction 262. For example, in the second state, the second housing part 220 may not be substantially movable with respect to the first housing part 210 in the first direction 261.

In the second state, the display 230 may provide the display area having a largest size. For example, in the second state, the display area may correspond to an area 230c including the first display area 230a and the second display area 230b. For example, the second display area 230b included in the first housing part 210 in the first state may be exposed in the second state. For example, in the second state, the first display area 230a may include a planar portion. However, it is not limited thereto. For example, the first display area 230a may include a curved portion extending from the planar portion and positioned in an edge portion. For example, in the second state, the second display area 230b may include a planar portion among the planar portion and a curved portion, unlike the first display area 230a in the first state. However, it is not limited thereto. For example, the second display area 230b may include a curved portion extending from the planar portion of the second display area 230b and positioned in an edge portion.

The second state may be referred to as a slide-out state or an open state in terms of at least a portion of the second housing part 220 disposed outside the first housing part 210 being extended with respect to the first state. For example, the second state may be referred to as an expanded state in terms of providing the display area having a largest size. However, it is not limited thereto.

The first image sensor 250-1 facing the third direction 263 may be moved together with the first display area 230a according to movement of the second housing part 220 in the first direction 261, when a state of the electronic device 101 is changed from the first state to the second state. For example, although not illustrated in FIG. 2C, the one or more second image sensors 250-2 facing the fourth direction 264 may be moved according to movement of the second housing part 220 in the first direction 261, when a state of the electronic device 101 is changed from the first state to the second state. For example, a relative positional relationship between the one or more second image sensors 250-2 and the structure exemplified through a description of FIG. 2D may be changed according to the movement of the one or more second image sensors 250-2. For example, the change in the relative positional relationship may be exemplified through FIG. 2D.

FIG. 2D is a bottom view of an electronic device according to an embodiment in a second state.

Referring to FIG. 2D, in the second state, the one or more second image sensors 250-2 may be positioned outside the structure. For example, the structure may include an opening 212a. For example, in the second state, the one or more second image sensors 250-2 may be positioned outside the opening 212a in the first plate 212. For example, the one or more second image sensors 250-2 may be exposed through the opening 212a in the first state. For example, since the one or more second image sensors 250-2 are positioned outside the first housing part 210 in the second state, the one or more second image sensors 250-2 may be exposed in the second state. For example, since the one or more second image sensors 250-2 are positioned outside the structure in the second state, the relative positional relationship in the second state may be different from the relative positional relationship in the first state.

When the electronic device 101 does not include the structure such as the opening 212a, the one or more second image sensors 250-2 may be exposed in the second state among the first state and the second state.

Although not illustrated in FIG. 2A, FIG. 2B, FIG. 2C, and FIG. 2D, the electronic device 101 may be in an intermediate state between the first state and the second state. A size of the display area in the intermediate state may be greater than a size of the display area in the first state and smaller than a size of the display area in the second state. The display area in the intermediate state may correspond to an area including the first display area 230a and a part of the second display area 230b. In the intermediate state, a part of the second display area 230b may be exposed, and another part (or a remaining part) of the second display area 230b may be covered by the first housing part 210 or may be rollable into the first housing part 210. However, it is not limited thereto.

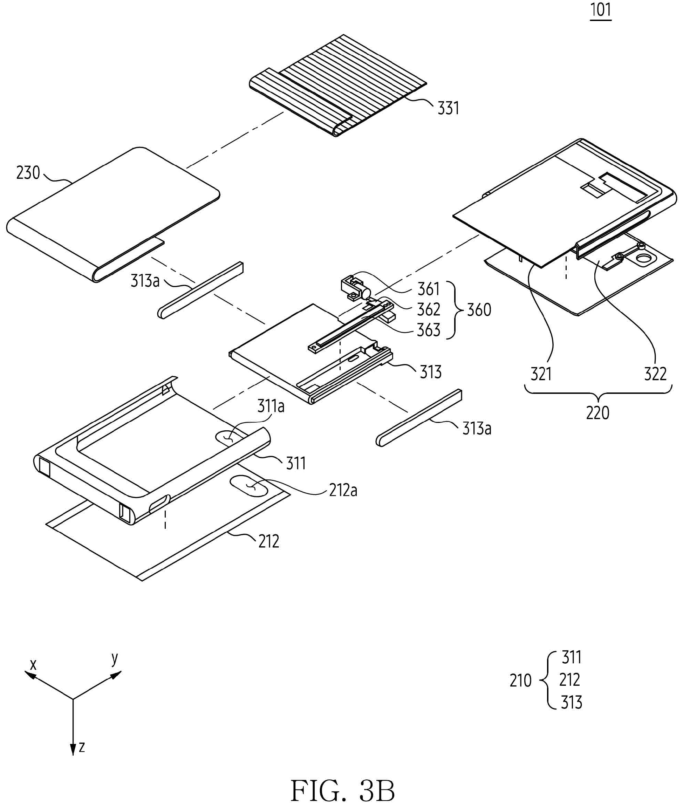

Referring again to FIG. 1, the electronic device 101 may include structures for moving a second housing (e.g., the second housing part 220 of FIG. 2A) of the electronic device 101 with respect to a first housing (e.g., the first housing part 210 of FIG. 2A) of the electronic device 101. The structures may be exemplified through descriptions of FIG. 3A and FIG. 3B.

FIGS. 3A and 3B are exploded perspective views of an electronic device according to an embodiment.

Referring to FIG. 3A and FIG. 3B, an electronic device 101 may include a first housing part 210, a second housing part 220, a display 230, and a driving unit 360.

The first housing part 210 may include a first cover 311, a first plate 212, and a frame 313.

The first cover 311 may at least partially form a side portion of an outer surface of the electronic device 101. The first cover 311 may include an opening 311a for one or more second image sensors 250-2. The first cover 311 may include a surface supporting the first plate 212. The first cover 311 may be coupled with the first plate 212. The first cover 311 may include the frame 313. The first cover 311 may be coupled with the frame 313.

The first plate 212 may at least partially form a rear portion of the outer surface. The first plate 212 may include an opening 212a for one or more second image sensors 250-2. The first plate 212 may be disposed on the surface of the first cover 311. The opening 212a may be aligned with the opening 311a.

The frame 313 may be at least partially surrounded by the first cover 311.

The frame 313 may be at least partially surrounded by the display 230. The frame 313 may be at least partially surrounded by the display 230, but a position of the frame 313 may be maintained independently of movement of the display 230. The frame 313 may be arranged with respect to at least a portion of components of the display 230. The frame 313 may include rails 313a providing (or guiding) a path of movement of at least one component of the display 230.

The frame 313 may be coupled with at least one component of the electronic device 101. The frame 313 may support a battery 189. The battery 189 may be supported through a recess or a hole in a surface 313b of the frame 313. The frame 313 may be coupled with an end of a flexible printed circuit board (FPCB) 325 on a surface on the frame 313. Although not explicitly illustrated in FIG. 3A and FIG. 3B, another end of the FPCB 325 may be connected to a PCB 324 through at least one connector. The PCB 324 may be electrically connected, through the FPCB 325, to another PCB (not illustrated in FIG. 3A and FIG. 3B) supplying power to a motor 361.

The frame 313 may be coupled with at least one structure of the electronic device 101 for a plurality of states including the first state and the second state. The frame 313 may fasten the motor 361 of the driving unit 360.

The second housing part 220 may include a second cover 321 and a second plate 322.

The second cover 321 may be at least partially surrounded by the display 230. For example, the second cover 321 may be coupled with at least a portion of the first display area 230a of the display 230 surrounding the second cover 321.

The second cover 321 may be coupled with at least one component of the electronic device 101. For example, the second cover 321 may be coupled with a printed circuit board (PCB) 324 including components of the electronic device 101. The PCB 324 may include a processor (e.g., the processor 120 of FIG. 1). For example, the second cover 321 may support the one or more second image sensors 250-2.

The second cover 321 may be coupled with the second plate 322.

For example, the second plate 322 may be coupled with the second cover 321 to protect at least one component of the electronic device 101 coupled in the second cover 321 and/or at least one structure of the electronic device 101 coupled in the second cover 321. The second plate 322 may include a structure for the at least one component. For example, the second plate 322 may include one or more openings 326 for the one or more second image sensors 250-2. The one or more openings 326 may be aligned with the one or more second image sensors 250-2 disposed on the second cover 321. A size of each of the one or more openings 326 may correspond to a size of each of lenses included in the one or more second image sensors 250-2.

The electronic device 101 may include a support member 331 for supporting at least a portion of the display 230. The support member 331 may include a plurality of bars. For example, the plurality of bars may be coupled to each other. The support member 331 may support the second display area 230b of the display 230.

The driving unit 360 may include a motor 361, a pinion gear 362, and a rack gear 363.

For example, the motor 361 may operate based on power from the battery 189. The power may be provided to the motor 361 in response to the user input.

For example, the pinion gear 362 may be coupled with the motor 361 through a shaft. For example, the pinion gear 362 may be rotated based on the operation of the motor 361 transmitted through the shaft.

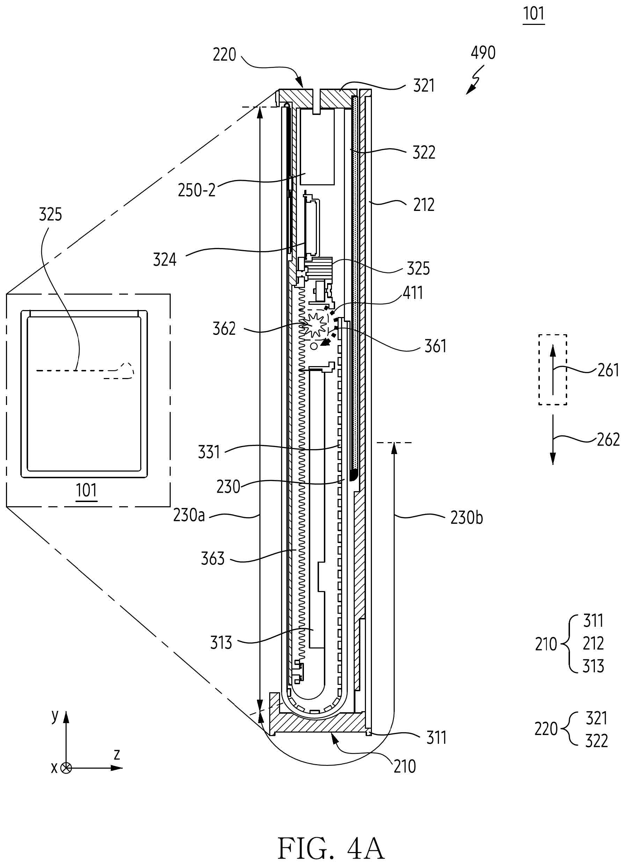

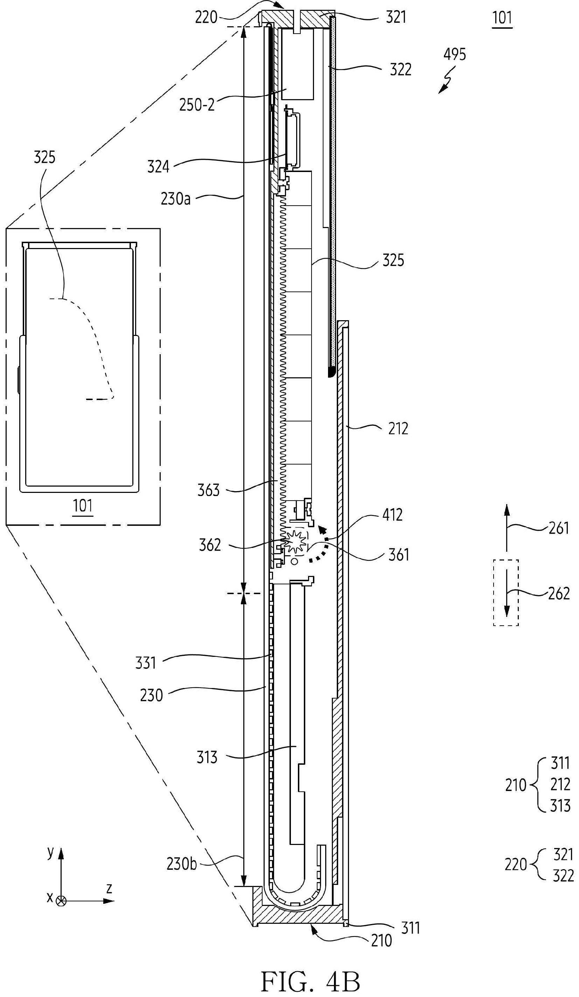

For example, the rack gear 363 may be arranged in relation to the pinion gear 362. Teeth of the rack gear 363 may be engaged with teeth of the pinion gear 362. The rack gear 363 may be moved in the first direction 261 or the second direction 262, according to rotation of the pinion gear 362. The rack gear 363 may be coupled with the first housing part 210 or the second housing part 220. The second housing part 220 may be moved in the first direction 261 and the second direction 262 by the rack gear 363 moved according to the rotation of the pinion gear 362 due to the operation of the motor 361. The first state of the electronic device 101 may be changed to a state (e.g., the one or more intermediate states or the second state) different from the first state, through the movement of the second housing part 220 in the first direction 261. The second state of the electronic device 101 may be changed to a state (e.g., the one or more intermediate states or the first state) different from the second state, through the movement of the second housing part 220 in the second direction 262. The first state being changed to the second state by the driving unit 360 and the second state being changed to the first state by the driving unit 360 may be exemplified through FIG. 4A and FIG. 4B.

FIG. 4A is a cross-sectional view of an electronic device according to an embodiment in a first state. FIG. 4B is a cross-sectional view of the electronic device according to an embodiment in a second state.

FIG. 4A is a cross-sectional view of the electronic device 101 according to an embodiment, cut along A-A' of FIG. 2A. FIG. 4B is a cross-sectional view of the electronic device 101 according to an embodiment, cut along B-B' of FIG. 2C.

Referring to FIG. 4A and FIG. 4B, the motor 361 may be operated based at least in part on the defined user input received in a state 490 which is the first state. For example, the pinion gear 362 may be rotated in a first rotation direction 411, based at least in part on the operation of the motor 361. For example, the rack gear 363 may be moved in the first direction 261, based at least in part on the rotation of the pinion gear 362 in the first rotation direction 411. The second housing part 220 may be moved in the first direction 261, based at least in part on the movement of the rack gear 363 in the first direction 261. The second cover 321 in the second housing part 220 may be moved, based at least in part on the movement of the rack gear 363 in the first direction 261. The display 230 may be moved along the rails 313a. A shape of at least a portion of the plurality of bars of the support member 331 of the display 230 may be changed when the state 490 is changed to a state 495 which is the second state.

The second display area 230b of the display 230 may be moved according to the movement of the display 230. The second display area 230b may be moved through a space between the first cover 311 and the frame 313 when the state 490 is changed to the state 495 according to the defined user input. The second display area 230b in the state 495 may be exposed, unlike the second display area 230b rolled into the space in the state 490.

Since the second cover 321 in the second housing part 220 is coupled with the PCB 324 connected with the another end of the FPCB 325 and fastens the rack gear 363, a shape of the FPCB 325 may be changed when the state 490 is changed to the state 495.

The motor 361 may be operated based at least in part on the defined user input received in the state 495. The pinion gear 362 may be rotated in a second rotation direction 412, based at least in part on the operation of the motor 361. The rack gear 363 may be moved in the second direction 262, based at least in part on the rotation of the pinion gear 362 in the second rotation direction 412. The second housing part 220 may be moved in the second direction 262, based at least in part on the movement of the rack gear 363 in the second direction 262. The display 230 may be moved, based at least in part on the movement of the rack gear 363 in the second direction 262. The display 230 may be moved along the rails 313a. A shape of at least a portion of the plurality of bars of the support member 331 of the display 230 may be changed when the state 495 is changed to the state 490. The support member 331 may be moved with respect to the first housing part 210. The support member 331 accommodated inside the first housing part 210 in the state 490 may be positioned between the first cover 311 and the frame 313. The display 230 may be moved with respect to the first housing part 210 according to the movement of the support member 331.

The second display area 230b of the display 230 may be moved according to the movement of the display 230. The second display area 230b may be moved through a space between the first cover 311 and the frame 313 when the state 495 is changed to the state 490 according to the defined user input. The second display area 230b in the state 490 may be rolled into the space, unlike the second display area 230b exposed in the state 495.

Since the second cover 321 of the second housing part 220 is coupled with the PCB 324 connected with the another end of the FPCB 325 and fastens the rack gear 363, a shape of the FPCB 325 may be changed when the state 495 is changed to the state 490.

Since the electronic device 101 includes a structure and/or components for slide movement, a space for mounting an antenna may be insufficient. The flexible display 230 of the electronic device 101 may be positioned at least partially in the housing 201. A driving unit (e.g., a motor, a rack gear, and/or a pinion gear) for slide movement of the second housing part 220 may be positioned within the housing 201. For example, a space for mounting an antenna may be insufficient due to the structures and/or the components.

The electronic device 101 according to an embodiment may improve shortage of a space for arranging an antenna, by using at least a portion of a conductive sheet 540 of the flexible display 230 occupying an inner space of the housing 201 as an antenna radiator.

Hereinafter, one or more components to be described later with reference to drawings may be implemented together with components of the electronic device 101 described with reference to FIG. 1 to FIG. 4B. The same reference numeral may be given to the same component as the above-described component, and overlapping descriptions may be omitted.

In the present disclosure, relative terms such as a front surface and a rear surface are described based on directions illustrated in the drawings for convenience of description and are not intended as absolute terms. For example, the front surface and the rear surface are used as terms for referring to surfaces opposite to each other and are not limited to absolute directions.

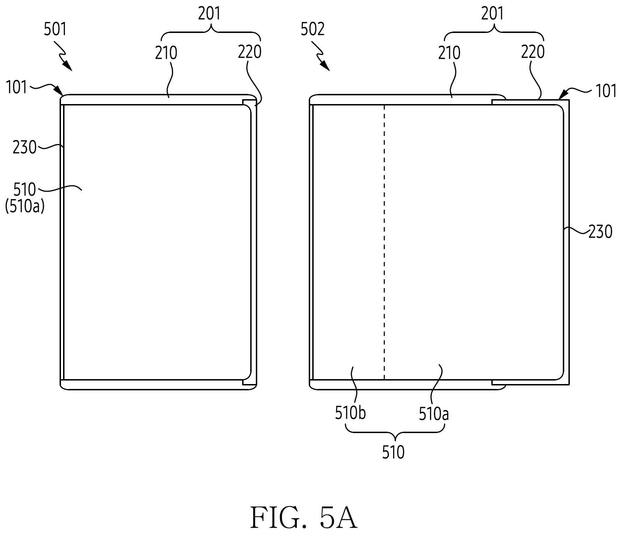

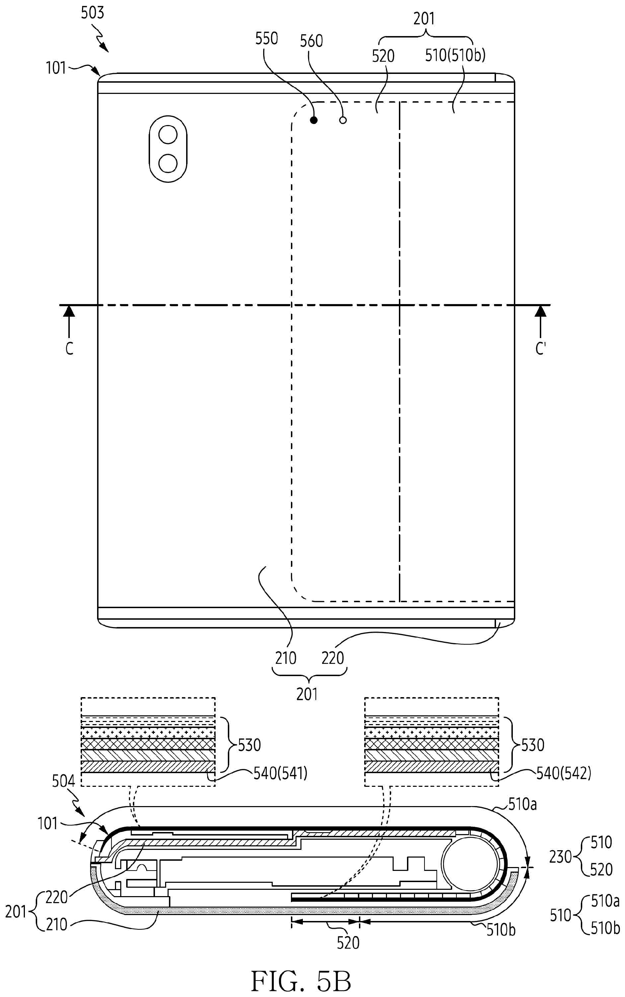

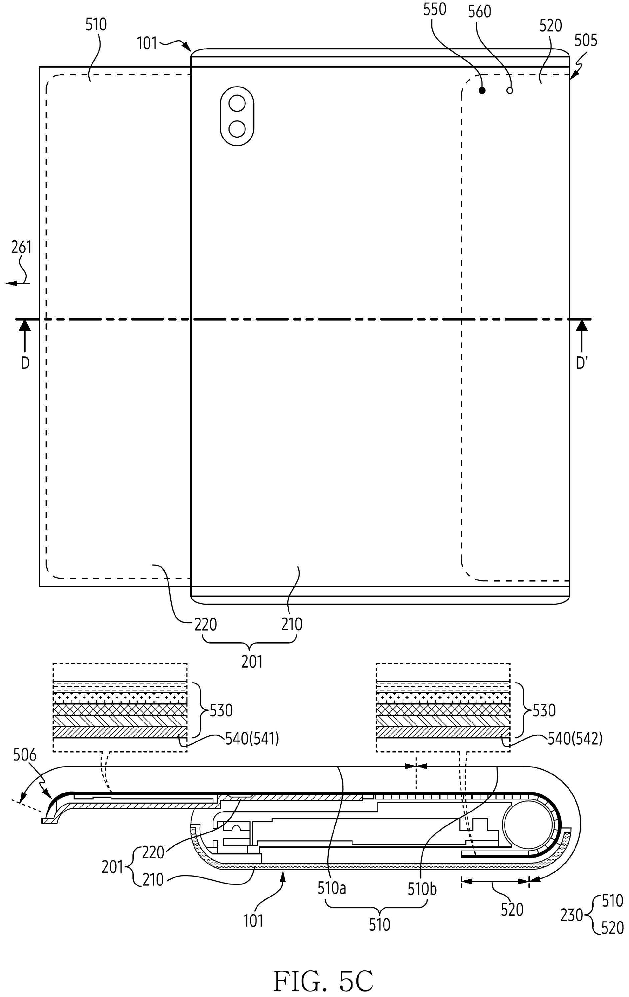

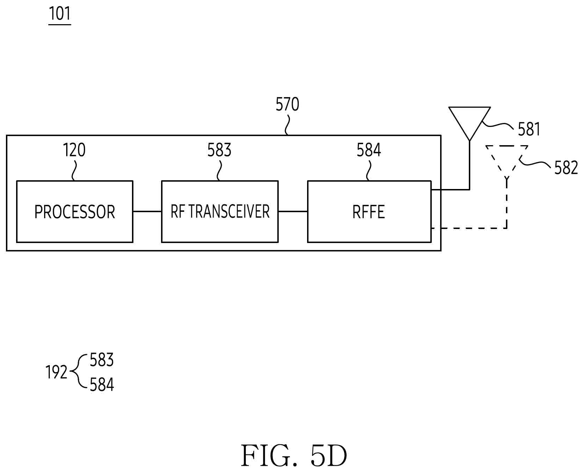

FIG. 5A illustrates a front surface of an electronic device according to an embodiment. FIG. 5B illustrates a rear surface and an inside of an electronic device according to an embodiment when the electronic device is in a first state. FIG. 5C illustrates a rear surface and an inside of an electronic device according to an embodiment when the electronic device is in a second state. FIG. 5D is a block diagram of an electronic device according to an embodiment.

Referring to FIG. 5A, an electronic device 101 according to an embodiment may include a housing 201 and a flexible display 230.

The housing 201 may include a first housing part 210 and a second housing part 220. For example, the second housing part 220 may be movably connected to the first housing part 210. For example, an image 501 of FIG. 5A illustrates a front surface of the electronic device 101 in a first state in which the second housing part 220 is maximally inserted into the first housing part 210. For example, an image 502 of FIG. 5A illustrates a front surface of the electronic device 101 in a second state in which the second housing part 220 is maximally extracted to the outside of the first housing part 210. Although not illustrated, the electronic device 101 may be in a plurality of intermediate states between the first state and the second state.

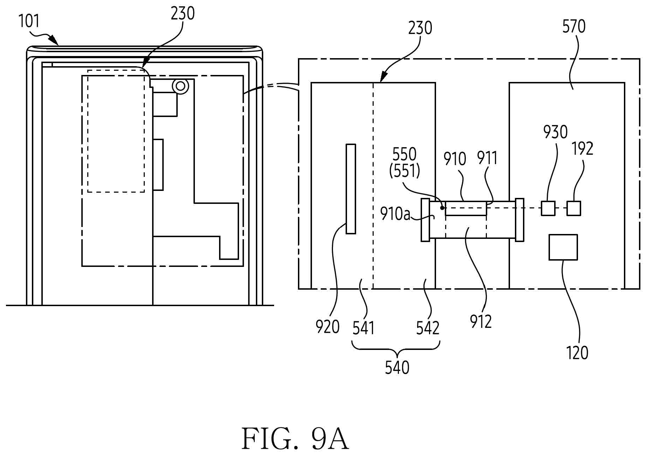

At least a portion of the flexible display 230 may be exposed to the outside of the housing 201. For example, the flexible display 230 may include an active area 510. For example, the active area 510 may be referred to as a display area displaying visual information. For example, the active area 510 may include a plurality of pixels for displaying visual information. The plurality of pixels may display visual information by being controlled by a display driver integrated circuit (DDI) (e.g., a display driver integrated circuit 920 of FIG. 9A). For example, the active area 510 may provide visual information to a user by being positioned outside the housing 201 in a first state, a second state, and/or a plurality of intermediate states.

A size of the active area 510 exposed to the outside of the housing 201 may be different based on a state of the electronic device 101. For example, in the first state, a size of the active area 510 exposed to the outside of the housing 201 may be minimum. For example, in the second state, a size of the active area 510 exposed to the outside of the housing 201 may be maximum. For example, in the plurality of intermediate states, a size of the active area 510 positioned outside the housing 201 may be greater than in the first state and smaller than in the second state. A user may adjust a size of the active area 510 exposed to the outside of the housing 201 by controlling a state of the electronic device 101. As a size of the active area 510 exposed to the outside of the housing 201 is adjusted, a size of visual information displayed in the active area 510 may be adjusted.

In the first state, a part 510a of the active area 510 may be positioned outside the housing 201. For example, in the first state, another part (e.g., another part 510b of the image 502) of the active area 510 may not be visible by being positioned within the housing 201. For example, when the electronic device 101 is changed from the first state to the second state, the another part 510b of the active area 510 positioned within the housing 201 in the first state may be visible by being positioned outside the housing 201.

Referring to FIG. 5B and FIG. 5C, a part of the flexible display 230 may be positioned within the housing 201 in the first state, the second state, and/or the plurality of intermediate states. For example, an image 503 of FIG. 5B illustrates a rear surface of the electronic device 101 in the first state. For example, an image 504 of FIG. 5B is a cross-sectional view of the electronic device 101 according to an embodiment cut along C-C' of the image 503 of FIG. 5B.

Referring to the image 503 and the image 504 of FIG. 5B, in the first state, a part of the active area 510 may be positioned within the housing 201. For example, the first state is a state in which a size of the flexible display 230 exposed to the outside of the housing 201 is minimum, and in the first state, a part (e.g., the part 510a of FIG. 5A) of the active area 510 may be positioned outside the housing 201. In the first state, another part 510b of the active area 510 may be positioned within the housing 201. For example, the another part 510b of the active area 510 positioned within the housing 201 may be covered by the first housing part 210.

For example, an image 505 of FIG. 5C illustrates a rear surface of the electronic device 101 in the second state. For example, an image 506 of FIG. 5B is a cross-sectional view of the electronic device 101 according to an embodiment cut along D-D' of the image 505 of FIG. 5B.

Referring to the image 505 and the image 506 of FIG. 5C, in order for the electronic device 101 to be changed from the first state to the second state, the second housing part 220 may move in the first direction 261. For example, by the movement of the second housing part 220 in the first direction 261, the another part 510b of the active area 510 positioned within the housing 201 may be moved at least partially to the outside of the housing 201. For example, as the another part 510b of the active area 510 is extracted at least partially to the outside of the housing 201, in the second state, a size of the active area 510 visible from the outside of the housing 201 may be increased. For example, referring to the image 506 of FIG. 5B, the another part 510b of the active area 510 may be positioned within the first housing part 210 at least partially in a bent state.

Referring to FIG. 5B and FIG. 5C, the flexible display 230 may include a non-active area 520. For example, the non-active area 520 may extend from the another part 510b of the active area 510 toward the inside of the housing 201. For example, the non-active area 520 may be a part of the flexible display 230 not visible from the outside, by being positioned within the housing 201 independently of a state of the electronic device 101. For example, since the non-active area 520 is always positioned within the housing 201, the non-active area 520 may be an area not including a plurality of pixels for displaying visual information. For example, the non-active area 520 may maintain a substantially flat shape independently of movement of the second housing part 220. For example, the non-active area 520 may be substantially flat in the first state and the second state. However, it is not limited thereto. For example, the non-active area 520 may be partially bent in the second state of the electronic device 101 illustrated in FIG. 5C. For example, the non-active area 520 may be referred to as a hidden area in that it is not visible from the outside.

For example, since the non-active area 520 is positioned within the housing 201 independently of movement of the second housing part 220, it may occupy an inner space of the housing 201. Since a part of the flexible display 230 is positioned within the housing 201, a space for arranging another component inside the housing 201 may be insufficient in the electronic device 101 according to an embodiment. For example, a plurality of antennas may be included in the electronic device 101 to communicate with an external electronic device by using a signal on a plurality of frequency bands. For example, since the non-active area 520 occupies an inner space of the housing 201, a space for arranging the plurality of antennas may be insufficient. The electronic device 101 according to an embodiment may be configured to communicate with an external electronic device by using at least a portion of the non-active area 520 as an antenna radiator.

Referring to FIG. 5D, the electronic device 101 according to an embodiment may include a processor 120, wireless communication circuitry (e.g., the wireless communication module 192 of FIG. 1), a first antenna 581, and/or a second antenna 582.

The processor 120 may include processing circuitry. The processor 120 may include an application processor (AP) (e.g., central processing unit (CPU)) and/or a communication processor (CP) (e.g., a modem), but is not limited thereto. The processor 120 may include a graphic processing unit (e.g., GPU), a neural processing unit (NPU) (e.g., artificial intelligence (AI) chip)), a wireless-fidelity (Wi-Fi) chip, a Bluetooth^{TM} chip, a global positioning system (GPS) chip, a near field communication (NFC) chip, connectivity chips, a sensor controller, a touch controller, a finger-print sensor controller, a display drive integrated circuit (DDI), an audio CODEC chip, a universal serial bus (USB) controller, a camera controller, an image processing IC, a microprocessor unit (MPU), a system on chip (SoC), an IC, or a circuit similar thereto.

The wireless communication circuitry 192 may include a radio frequency (RF) transceiver 583 and a radio frequency front end (RFFE) 584.

The processor 120 may generate a baseband signal. The processor 120 may control the RF transceiver 583 to process the generated baseband signal. The processor 120 may control the RF transceiver 583 so that a transmission signal is transmitted through the first antenna 581 and/or the second antenna 582. The processor 120 may control the RF transceiver 583 so that the transmission signal is transmitted in a frequency band communicable with an external electronic device.

The RF transceiver 583 may be implemented as a single chip (e.g., RFIC chip) or a part of a single package. The RF transceiver 583 may include a digital to analog converter (DAC) for converting a digital signal into an analog signal. The RF transceiver 583 may include a mixer and an oscillator (e.g., local oscillator (LO)) for up-conversion. The RF transceiver 583 may convert a baseband signal generated by the processor 120 into an RF signal. The RF transceiver 583 may include an analog to digital converter (ADC) for converting an analog signal into a digital signal. The RF transceiver 583 may include a mixer and an oscillator for down-conversion. The RF transceiver 583 may convert an RF signal received from the first antenna 581 and/or the second antenna 582 into a baseband signal to be processed by the processor 120.

The RFFE 584 may include a plurality of components electrically connected between the RF transceiver 583 and an antenna (e.g., the first antenna 581 and/or the second antenna 582). For example, the RFFE 584 may include components such as a coupler, a power amplifier (PA), a low noise amplifier (LNA), a switch circuit, and/or a duplexer, but is not limited thereto.

For example, the first antenna 581 and/or the second antenna 582 may be used to transmit and/or receive a signal on a designated frequency band. For example, the first antenna 581 and/or the second antenna 582 may include a feed point to which a feed signal provided from the RF transceiver 583 is provided and a ground point electrically connected to a ground of the electronic device 101. For example, the first antenna 581 and/or the second antenna 582 may include an antenna radiator which is a physical configuration for radiating or receiving an electromagnetic wave. For example, the first antenna 581 and/or the second antenna 582 may use at least a portion of the non-active area 520 of the flexible display 230 as an antenna radiator.

The electronic device 101 according to an embodiment may include a connection member for electrically connecting the wireless communication circuitry 192 to the first antenna 581 and/or the second antenna 582. For example, the processor 120 and the wireless communication circuitry 192 may be disposed on a printed circuit board 570. For example, the first antenna 581 and/or the second antenna 582 may be electrically connected to the printed circuit board 570 on which the wireless communication circuit 192 is disposed, through the connection member. For example, the connection member may include a c-clip, a conductive poron, and/or a conductive pin for electrically connecting the printed circuit board 570 to the first antenna 581 and/or the second antenna 582, but is not limited thereto.

Referring again to FIG. 5B, the flexible display 230 may include a plurality of layers 530. For example, the plurality of layers 530 may include a display panel on which a plurality of pixels are disposed, an electromagnetic induction panel for receiving an input from an external electronic device (e.g., an electronic pen and/or a stylus pen), an adhesive layer, a polarizing layer, and/or a waterproof layer, but is not limited thereto. For example, the flexible display 230 may include a conductive sheet 540 forming a layer among the plurality of layers 530. For example, the conductive sheet 540 may include a conductive material (e.g., copper).

For example, the conductive sheet 540 may include an electrostatic discharge (ESD) sheet, a support sheet, and/or a noise shielding sheet. For example, the ESD sheet may be configured to reduce malfunction and damage of an electronic component due to static electricity generated from the electronic device 101 by inducing the static electricity to the outside. For example, the ESD sheet may include a conductive material to induce static electricity. For example, the support sheet may protect the flexible display 230 from an external force by supporting the plurality of layers 530. For example, the support sheet may include a conductive material to have rigidity. For example, the noise shielding sheet may reduce electromagnetic interference between the flexible display 230 and another electronic component. For example, the noise shielding sheet may include a conductive material to reduce an electromagnetic wave. The examples of the conductive sheet 540 described above are merely exemplary and are not limited thereto.

For example, the conductive sheet 540 may include a first part (or a first portion) 541 and a second part (or a second portion) 542. For example, the first part 541 may be a part of the conductive sheet 540 positioned within the active area 510. For example, the second part 542 may be a part of the conductive sheet 540 positioned within the non-active area 520. For example, at least a portion of the second part 542 positioned within the non-active area 520 may operate as an antenna radiator used for communication with an external electronic device. For example, since the second part 542 is positioned within the non-active area 520, the second part 542 may be positioned within the housing 201 independently of movement of the second housing part 220. A shape of the second part 542 may correspond to a shape of the non-active area 520. For example, when the non-active area 520 maintains a substantially flat shape, the second part 542 may also maintain a flat shape. However, it is not limited thereto. As described above, when the non-active area 520 is partially bent in the second state, the second part 542 may be partially bent.

For example, the second part 542 may include at least one feed point 550 and at least one ground point 560. For example, the at least one feed point 550 may be electrically connected to wireless communication circuitry (e.g., the wireless communication circuitry 192 of FIG. 5D). For example, at least a portion of the second part 542 may radiate an electromagnetic wave based on power provided from the RF transceiver 583 to the at least one feed point 550. For example, the at least one ground point 560 may reduce reflection and/or interference of the electromagnetic wave and maintain performance of an antenna, by being electrically connected to a ground of the electronic device 101. For example, at least a portion of the second part 542 used as an antenna radiator may be distinguished from another part of the conductive sheet 540 by the at least one ground point 560. For example, the above-described connection member may electrically connect the at least one feed point 550 to the wireless communication circuitry 192. For example, the above-described connection member may electrically connect the at least one ground point 560 to the ground.

For example, at least a portion of the second part 542 may transmit a signal to an external electronic device and/or receive a signal from the external electronic device, by radiating an electromagnetic wave based on power provided to the at least one feed point 550. For example, an electromagnetic wave radiated through at least a portion of the second part 542 may be radiated in a direction toward which a rear surface of the first housing part 210 substantially faces. The electronic device 101 according to an embodiment may communicate with an external electronic device by using at least a portion of the second part 542 of the flexible display 230.

For example, the second part 542 used as an antenna radiator may be electrically distinguished from the first part 541 by the at least one ground point 560. For example, when power is provided to the at least one feed point 550, a radiation current may be formed along at least a portion of the second part 542. An electromagnetic field may be formed by the radiation current. An electromagnetic wave may be radiated through at least a portion of the second part 542 by the electromagnetic field. Since the radiation current may flow to a ground through the at least one ground point 560 electrically connected to the ground, an area in which an electromagnetic field is formed may be limited. An antenna including at least a portion of the second part 542 may be configured to radiate and/or receive a signal on a designated frequency, by using at least a portion of the second part 542 electrically distinguished by the at least one feed point 550 and the at least one ground point 560 as an antenna radiator. When the at least one ground point 560 is positioned within the second part 542, an electromagnetic field may be substantially formed in the second part 542, so the second part 542 operating as the antenna radiator may be distinguished from the first part 541.

For example, the conductive sheet 540 may at least partially form a rear surface of the flexible display 230. The rear surface of the flexible display 230 may be opposite to a front surface of the flexible display 230 on which visual information is visible. For example, the conductive sheet 540 may be positioned at an outermost location among the plurality of layers 530, by at least partially forming the rear surface of the flexible display 230. For example, since the conductive sheet 540 is positioned at the outermost location among the plurality of layers 530, interference of other components of the flexible display 230 with respect to an electromagnetic wave radiated through at least a portion of the second part 542 may be reduced.

For example, since the active area 510 includes a plurality of pixels for displaying visual information, it may be difficult to be electrically connected with a physical connection member. For example, when forming at least one feed point 550 and at least one ground point 560 in the active area 510 to use at least a portion of the active area 510 as an antenna radiator, the plurality of pixels may be easily damaged by contact with the physical connection member. For example, when the plurality of pixels are damaged, the flexible display 230 may not perform providing visual information, which is an essential function of the flexible display 230. For example, since the non-active area 520 does not include a plurality of pixels, it may be used as an antenna radiator by contacting a physical connection member regardless of providing visual information. The electronic device 101 according to an embodiment may improve utilization of a limited inner space of the housing 201, by using at least a portion of the second part 542 of the conductive sheet 540 positioned in the non-active area 520 occupying an inner space of the housing 201 as an antenna radiator.

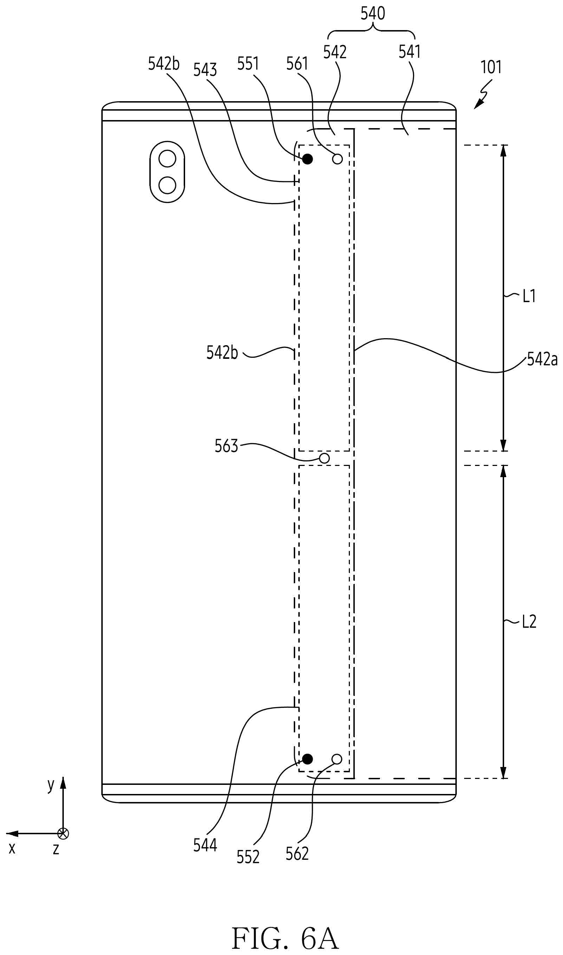

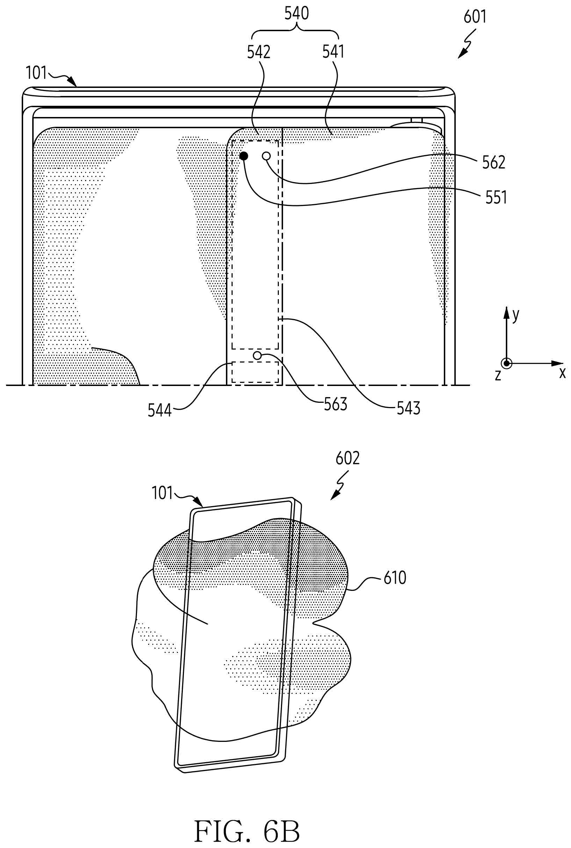

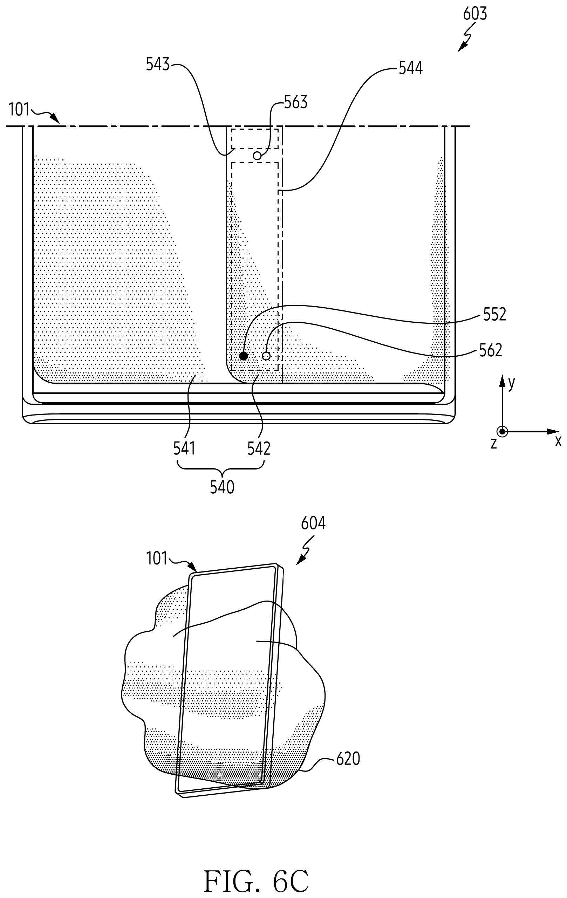

FIG. 6A illustrates a rear surface of an electronic device according to an embodiment. FIG. 6B schematically illustrates an electromagnetic field and a radiation pattern formed when a part of an exemplary conductive sheet operates as an antenna radiator. FIG. 6C schematically illustrates an electromagnetic field and a radiation pattern formed when another part of an exemplary conductive sheet operates as an antenna radiator.

Referring to FIG. 6A, the second part 542 of the conductive sheet 540 may be implemented as one or more antenna radiators. For example, the second part 542 may include a third part 543 and a fourth part 544.

For example, the second part 542 of the conductive sheet 540 used as an antenna radiator may be positioned within a non-active area (e.g., the non-active area 520 of FIG. 5B). For example, the second part 542 may include a third part 543 and a fourth part 544 distinguished by at least one third ground point 563 electrically connected to a ground of the electronic device 101.

For example, the third part 543 may include a first feed point 551 and a first ground point 561. For example, the fourth part 544 may include a second feed point 552 and a second ground point 562. For example, the first feed point 551 and the second feed point 552 may be positioned closer to a second boundary 542b opposite to a first boundary 542a than to the first boundary 542a contacting the first part 541 among boundaries of the second part 542.

For example, wireless communication circuitry (e.g., the wireless communication circuitry 192 of FIG. 5D) may be configured to communicate with an external electronic device by using at least a portion of the third part 543 and/or at least a portion of the fourth part 544 distinguished by the at least one third ground point 563.

For example, at least a portion of the third part 543 may be configured to transmit and/or receive a signal on a first frequency. For example, a signal on the first frequency provided from the wireless communication circuitry 192 to the third part 543 may be radiated to the outside through at least a portion of the third part 543. For example, a signal on the first frequency transmitted from an external electronic device may be received by the wireless communication circuitry 192 through at least a portion of the third part 543.

For example, at least a portion of the fourth part 544 may be configured to transmit and/or receive a signal on a second frequency. For example, a signal on the second frequency provided from the wireless communication circuitry 192 to the fourth part 544 may be radiated to the outside through at least a portion of the fourth part 544. For example, a signal on the second frequency transmitted from an external electronic device may be received by the wireless communication circuitry 192 through at least a portion of the fourth part 544. For example, the second frequency may correspond to the first frequency or may be different from the first frequency. Descriptions of the first frequency and the second frequency will be described later.

For example, the third part 543 and the fourth part 544 may be distinguished by at least one third ground point 563 positioned between the third part 543 and the fourth part 544. For example, the third part 543 and the fourth part 544 being distinguished may be referred to as an area in which an electromagnetic field is formed being distinguished in terms of a perspective of an antenna radiator for radiation of an RF signal, rather than being physically distinguished. For example, when power is provided to the first feed point 551, an electromagnetic wave including a signal on the first frequency may be radiated by an electromagnetic field formed in at least a portion of the third part 543. For example, a first antenna including at least a portion of the third part 543 may be configured to radiate and/or receive a signal on the first frequency by using at least a portion of the third part 543 electrically distinguished by the first feed point 551 and a ground point (e.g., the first ground point 561 and the third ground point 563) as an antenna radiator. While the third part 543 radiates an electromagnetic wave, the fourth part 544 may not operate as an antenna radiator by being electrically distinguished from the third part 543 by the at least one third ground point 563. For example, when power is provided to the second feed point 552, an electromagnetic wave including a signal on the second frequency may be radiated by an electromagnetic field formed in at least a portion of the fourth part 544. For example, a first antenna including at least a portion of the fourth part 544 may be configured to radiate and/or receive a signal on the second frequency, by using at least a portion of the fourth part 544 electrically distinguished by the second feed point 552 and a ground point (e.g., the second ground point 562 and the third ground point 563) as an antenna radiator. While the fourth part 544 radiates an electromagnetic wave, the third part 543 may not operate as an antenna radiator by being electrically distinguished from the fourth part 544 by the at least one third ground point 563.

Referring to FIG. 6B, 601 of FIG. 6B schematically illustrates an electromagnetic field formed in the conductive sheet 540 when an antenna (e.g., a first antenna) including the third part 543 of the conductive sheet 540 operates. 602 of FIG. 6B schematically illustrates a radiation pattern 610 formed in the electronic device 101 when the first antenna operates.

Referring to 601 of FIG. 6B, when the first antenna operates, a radiation current may be formed along at least a portion of the third part 543. For example, when power is provided to the first feed point 551, a radiation current may be formed along at least a portion of the third part 543. The radiation current may cause an electromagnetic field formed along at least a portion of the third part 543. For example, since at least one third ground point 563 is positioned between the third part 543 and the fourth part 544, the electromagnetic field may be formed substantially along at least a portion of the third part 543 without being substantially excited in the fourth part 544. For example, the electromagnetic field may be strongly formed along a boundary of the third part 543. By the electromagnetic field, an electromagnetic wave including a signal on the first frequency may be radiated from at least a portion of the third part 543.

Referring to 602 of FIG. 6B, a radiation pattern 610 formed in the electronic device 101 may indicate intensity and a direction of an electromagnetic wave radiated from the first antenna. For example, a first antenna including at least a portion of the third part 543 may be configured to radiate and/or receive a signal on the first frequency by using at least a portion of the third part 543 as an antenna radiator. For example, when power is provided to the first feed point 551, an electromagnetic wave may be radiated by an electromagnetic field formed along at least a portion of the third part 543. Since the electromagnetic wave is strongly formed in an area where the electromagnetic field is strong, the radiation pattern 610 may strongly appear in a portion of the housing 201 corresponding to the third part 543. For example, when the third part 543 is positioned above the fourth part 544 (e.g., in +y direction), a radiation pattern 610 toward an upper portion of the housing 201 may be formed.

Referring to FIG. 6C, 603 of FIG. 6C schematically illustrates an electromagnetic field formed in the conductive sheet 540 when an antenna (e.g., a second antenna) including the fourth part 544 of the conductive sheet 540 operates. 603 of FIG. 6C schematically illustrates a radiation pattern 620 formed in the electronic device 101 when the second antenna operates.

Referring to 603 of FIG. 6C, when the second antenna operates, a radiation current may be formed along at least a portion of the fourth part 544. For example, when power is provided to the second feed point 552, a radiation current may be formed along at least a portion of the fourth part 544. The radiation current may cause an electromagnetic field formed along at least a portion of the fourth part 544. For example, since at least one third ground point 563 is positioned between the third part 543 and the fourth part 544, the electromagnetic field may be formed substantially along at least a portion of the fourth part 544 without being substantially excited in the third part 543. For example, the electromagnetic field may be strongly formed along a boundary of the fourth part 544. By the electromagnetic field, an electromagnetic wave including a signal on the second frequency may be radiated from at least a portion of the fourth part 544.

Referring to 603 of FIG. 6C, a radiation pattern 620 formed in the electronic device 101 may indicate intensity and a direction of an electromagnetic wave radiated from the second antenna. For example, the second antenna including at least a portion of the fourth part 544 may be configured to radiate and/or receive a signal on the second frequency by using at least a portion of the fourth part 544 as an antenna radiator. For example, when power is provided to the second feed point 552, an electromagnetic wave may be radiated by an electromagnetic field formed along at least a portion of the fourth part 544. Since the electromagnetic wave is strongly formed in an area where the electromagnetic field is strong, the radiation pattern 620 may strongly appear in a portion of the housing 201 corresponding to the fourth part 544. For example, when the fourth part 544 is positioned below the third part 543 (e.g., in -y direction), the radiation pattern 620 toward a lower portion of the housing 201 may be formed.

For example, a frequency characteristic (e.g., a resonance frequency) of the first antenna including the third part 543 and the second antenna including the fourth part 544 may be set based on a location of at least one third ground point 563. Referring again to FIG. 6A, for example, an electrical length L1 of the third part 543 and an electrical length L2 of the fourth part 544 may be set by a location of at least one third ground point 563. For example, when the at least one third ground point 563 includes one ground point and is positioned substantially at a center with respect to a longitudinal direction (e.g., y-axis direction) of the second part 542, the electrical length L1 of the third part 543 may be substantially equal to the electrical length L2 of the fourth part 544. For example, when a wavelength corresponding to a resonance frequency of a signal transmitted and/or received through an antenna is λ, an electrical length of an antenna radiator may be 1/4 λ to 1/2 λ. For example, when the electrical length L1 of the third part 543 and the electrical length L2 of the fourth part 544 distinguished by the at least one third ground point 563 are substantially the same, the first frequency and the second frequency may be substantially the same.

For example, the first antenna and the second antenna may be used to transmit and/or receive a signal on a designated frequency band. For example, the electronic device 101 may implement a diversity function and/or a multiple-input and multiple-output (MIMO) function, by using the first antenna and the second antenna. For example, the first antenna may operate as a primary antenna, and the second antenna may operate as a diversity antenna. However, it is not limited thereto.

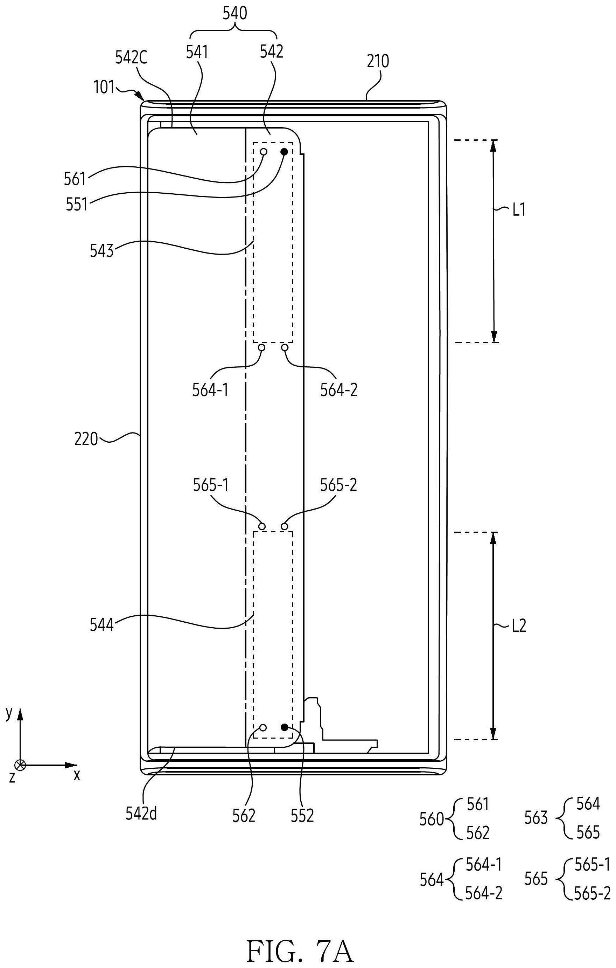

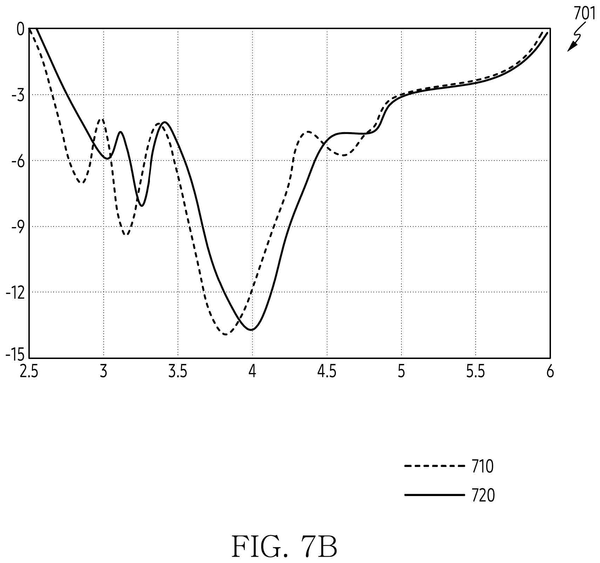

FIG. 7A illustrates a rear surface of an electronic device according to an embodiment. FIG. 7B is a graph showing an S-parameter of an antenna in a first state or a second state of the electronic device illustrated in FIG. 7A.

Referring to FIG. 7A, at least one third ground point 563 positioned between the third part 543 and the fourth part 544 may be plural. For example, the at least one third ground point 563 may include two ground points (e.g., a fourth ground point 564 and a fifth ground point 565) to set the electrical length L1 of the third part 543 and/or the electrical length L2 of the fourth part 544.

For example, the fourth ground point 564 and the fifth ground point 565 may be positioned between the third part 543 and the fourth part 544. For example, the fourth ground point 564 may be closer to the third part 543 among the third part 543 and the fourth part 544, within the second part 542. For example, the fifth ground point 565 may be closer to the fourth part 544 among the third part 543 and the fourth part 544, within the second part 542. For example, the fifth ground point 565 may be spaced apart from the fourth ground point 564. However, it is not limited thereto. For example, the at least one third ground point 563 may be two or more to set the electrical length L1 of the third part 543 and/or the electrical length L2 of the fourth part 544. For example, the fourth ground point 564 may include two ground points 564-1 and 564-2 spaced apart along the x-axis. For example, the fifth ground point 565 may include two ground points 565-1 and 565-2 spaced apart along the x-axis.

For example, the electrical length L1 of the third part 543 may be set by the fourth ground point 564. For example, the electrical length L1 of the third part 543 may be formed from a third boundary 542c of the second part 542 perpendicular (e.g., in the x-axis direction) to a longitudinal direction (e.g., the y-axis direction) to a location of the fourth ground point 564. For example, the electrical length L2 of the fourth part 544 may be set by the fifth ground point 565. For example, the electrical length L2 of the fourth part 544 may be formed from a fourth boundary 542d of the second part 542 perpendicular (e.g., in the x-axis direction) to a longitudinal direction (e.g., the y-axis direction) to a location of the fifth ground point 565. For example, the electrical length L1 of the third part 543 and the electrical length L2 of the fourth part 544 may be about 35 mm, but are not limited thereto.

For example, a first frequency which is a frequency of a signal transmitted and/or received through the third part 543 may be set based on the electrical length L1 of the third part 543 based on the location of the fourth ground point 564. For example, when the electrical length L1 of the third part 543 is formed to be about 35 mm by the location of the fourth ground point 564, a first antenna including the third part 543 may form resonance at a frequency on about 4 GHz. For example, the first frequency may be about 4 GHz, but is not limited thereto.

For example, a second frequency which is a frequency of a signal transmitted and/or received through the fourth part 544 may be set based on the electrical length L2 of the fourth part 544 based on the location of the fifth ground point 565. For example, when the electrical length L2 of the fourth part 544 is formed to be about 35 mm by the location of the fifth ground point 565, a second antenna including the fourth part 544 may form resonance at a frequency on about 4 GHz. For example, the second frequency may be about 4 GHz, but is not limited thereto. For example, when the electrical length L2 of the fourth part 544 and/or an electrical length of a fifth part 545 are changed as a location of the fourth ground point 564 and/or the fifth ground point 565 is changed, the first frequency and/or the second frequency may be shifted. For example, a location of the fourth ground point 564 and/or the fifth ground point 565 may be adjusted based on a targeted frequency of a signal to be transmitted and/or received through the first antenna and/or the second antenna.

FIG. 7B is a graph 701 illustrating an S-parameter of an antenna (e.g., the first antenna and/or the second antenna) according to a state of the electronic device 101 illustrated in FIG. 7A. The x-axis of the graph 701 is a frequency (unit: giga hertz (GHz)), and the y-axis of the graph 701 is a reflection coefficient (unit: decibel (dB)).

For example, a first graph 710 is a graph indicating a reflection coefficient of the antenna in the first state. For example, a second graph 720 is a graph indicating a reflection coefficient of the antenna in the second state.

Referring to FIG. 7B, the antenna may have a resonance frequency on about 4 GHz indicating a lowest reflection coefficient. For example, when an electrical length (e.g., the length L1 of FIG. 7A) of a third part (e.g., the third part 543 of FIG. 7A) and/or an electrical length (e.g., the length L2 of FIG. 7A) of a fourth part (e.g., the fourth part 544 of FIG. 7A) are formed to be about 35 mm by a fourth ground point (e.g., the fourth ground point 564 of FIG. 7A) and/or a fifth ground point (e.g., the fifth ground point 565 of FIG. 7A), a resonance frequency of a first antenna including at least a portion of the third part 543 and/or a second antenna including at least a portion of the fourth part 544 may be about 4 GHz.

Comparing the first graph 710 and the second graph 720, even when a state of an electronic device (e.g., the electronic device 101 of FIG. 7A) is changed by movement of a second housing part (e.g., the second housing part 220 of FIG. 7A), a resonance frequency of the antenna may be substantially maintained. For example, the second part 542 may be electrically distinguished from the first part 541 by at least one ground point (e.g., the at least one ground point 560 of FIG. 7A) (e.g., the first ground point 561 and the second ground point 562). As described above, when the second part 542 is always flat independently of movement of the second housing part 220, the second part 542 may maintain a substantially constant shape. As described above, since the second part 542 is a part positioned within the non-active area 520 that is not always exposed to the outside independently of movement of the second housing part 220, the second part 542 may maintain a substantially constant size even when a state of the electronic device 101 is changed. For example, since a shape and a size of the second part 542 are substantially maintained constant, a resonance frequency of the antenna in the first state may be substantially identical to a resonance frequency of the antenna in the second state. For example, since a communication characteristic of the antenna are substantially maintained constant independently of a state of the electronic device 101, the electronic device 101 may have stable communication performance.

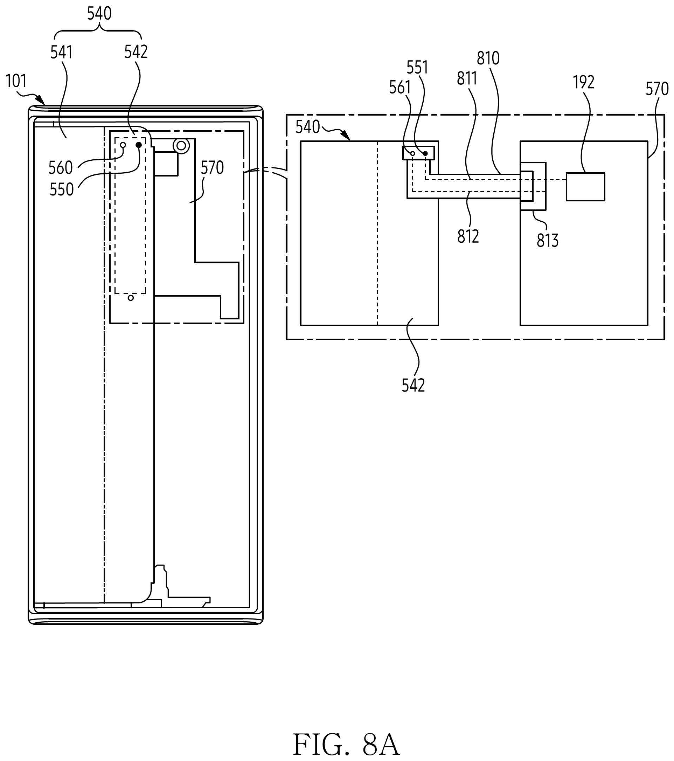

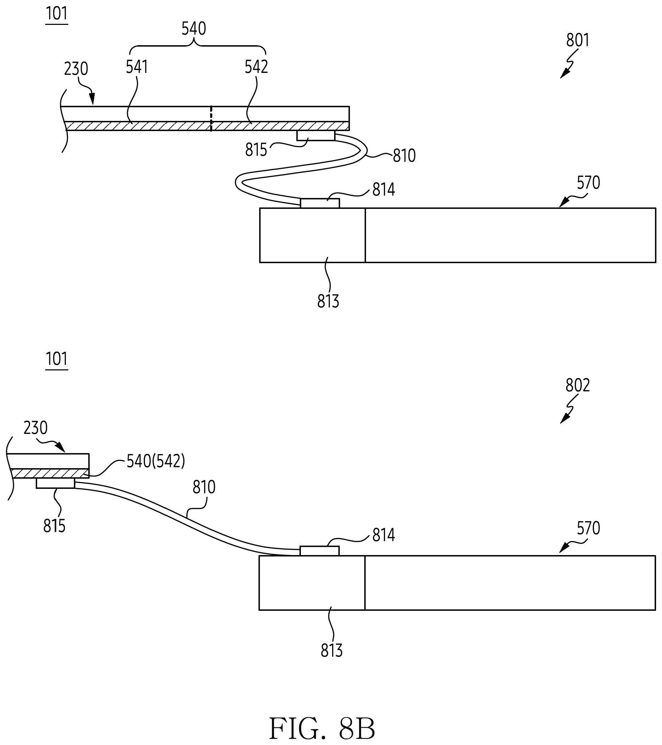

FIG. 8A illustrates a printed circuit board and a connection structure of an electronic device according to an embodiment. FIG. 8B illustrates a printed circuit board and a connection structure according to a state of an electronic device according to an embodiment.

Referring to FIG. 8A, the electronic device 101 according to an embodiment may include a printed circuit board 570 and a first connection structure 810.

For example, the printed circuit board 570 may include a plurality of conductive layers and a plurality of non-conductive layers alternately laminated with the plurality of conductive layers. For example, the printed circuit board 570 may provide an electrical connection between various electronic components by using wirings and conductive vias formed in the conductive layers. For example, the wireless communication circuitry 192 may be disposed on the printed circuit board 570 and may be electrically connected to at least one feed point 550 and at least one ground point 560 in the second part 542 of the conductive sheet 540 through the printed circuit board 570 and the first connection structure 810.

For example, a first connection structure 810 may electrically connect the printed circuit board 570 to at least one feed point 550 and at least one ground point 560. For example, the first connection structure 810 may include a flexible printed circuit board, but is not limited thereto. For example, the printed circuit board 570 may be spaced apart from the conductive sheet 540. For example, the first connection structure 810 may electrically connect the printed circuit board 570 to the at least one feed point 550 and the at least one ground point 560, by being connected to the printed circuit board 570 and the at least one feed point 550 and the at least one ground point 560 in the conductive sheet 540.

For example, the first connection structure 810 may include a first wiring 811 and a second wiring 812. For example, the first wiring 811 may electrically connect the wireless communication circuitry 192 and at least one feed point 550. For example, an end of the first wiring 811 may be connected to the printed circuit board 570, and another end of the first wiring 811 may be connected to the at least one feed point 550. For example, the second wiring 812 may electrically connect at least one ground point 560 and a ground layer of the printed circuit board 570 electrically connected to a ground of the electronic device 101. For example, an end of the second wiring 812 may be connected to the ground layer of the printed circuit board 570, and another end of the second wiring 812 may be connected to the at least one ground point 560. For example, an RF signal provided from the wireless communication circuitry 192 may be transmitted to the at least one feed point 550 through the first wiring 811. For example, the at least one ground point 560 may be electrically connected to the ground of the electronic device 101 through the second wiring 812 electrically connected to the ground layer. For example, the first wiring 811 may be a wiring transmitting a feed signal from the wireless communication circuitry 192 to the at least one feed point 550. For example, the second wiring 812 may be a ground wiring electrically connecting the at least one ground point 560 to a ground layer of the printed circuit board 570 or may be a ground layer formed in the first connection structure 810.

For example, the printed circuit board 570 may include a fill cut area 813. For example, the fill cut area 813 may be an area in which a ground layer (e.g., copper foil) is removed, and a ground layer may not be included in the fill cut area 813. For example, in order for an RF signal provided from the wireless communication circuitry 192 to the at least one feed point 550 to be radiated, a part of the printed circuit board 570 connected to the first wiring 811 may include the fill cut area 813. For example, a part of the first wiring 811 in the first connection structure 810 may be positioned within the fill cut area 813.

Referring to FIG. 8B, the printed circuit board 570 may be spaced apart from the flexible display 230. For example, 801 of FIG. 8B illustrates the flexible display 230 and the printed circuit board 570 when the electronic device 101 according to an embodiment is in the first state. For example, 802 of FIG. 8B illustrates the flexible display 230 and the printed circuit board 570 when the electronic device 101 according to an embodiment is in the second state.

For example, the first connection structure 810 may be deformable between the conductive sheet 540 and the printed circuit board 570 based on movement of the second housing part 220. For example, the first connection structure 810 may include a flexible printed circuit board having flexibility, but is not limited thereto. For example, since the flexible display 230 and the printed circuit board 570 are spaced apart from each other, a relative positional relationship between the flexible display 230 and the printed circuit board 570 may be changed as a state of the electronic device 101 is changed.

For example, the first connection structure 810 may include a first connector 814 coupled to the fill cut area 813 of the printed circuit board 570 and a second connector 815 coupled to the second part 542 of the conductive sheet 540. For example, a part of the first connection structure 810 between the first connector 814 and the second connector 815 may be at least partially bent or unfolded based on movement of the second housing part 220.

801 of FIG. 8B schematically illustrates the electronic device 101 in the first state. 802 of FIG. 8B schematically illustrates the electronic device 101 in the second state. Referring to 801 and 802 of FIG. 8B, since the flexible display 230 moves as a state of the electronic device 101 is changed, a relative positional relationship between the second part 542 and the printed circuit board 570 may be changed. For example, among a plurality of layers (e.g., the plurality of layers 530 of FIG. 5B) of the flexible display 230, the conductive sheet 540 positioned at an outermost location may face the printed circuit board 570. For example, referring to 801 of FIG. 8B, in the first state, according to a relative position between the second part 542 and the printed circuit board 570, the first connection structure 810 may be positioned between the conductive sheet 540 and the printed circuit board 570 in a state of being at least partially bent.

Referring to 802 of FIG. 8B, in the second state, since the flexible display 230 is moved by a second housing part (e.g., the second housing part 220 of FIG. 5A), a relative positional relationship between the flexible display 230 and the printed circuit board 570 may be changed. For example, as the first state is changed to the second state, the second part 542 may not overlap with the printed circuit board 570, or a size in which the second part 542 overlaps with the printed circuit board 570 may be reduced. For example, since the first connector 814 is coupled to and fixed to the printed circuit board 570 and the second connector 815 is coupled to and fixed to the second part 542, a distance between the first connector 814 and the second connector 815 may be increased as the electronic device 101 is changed from the first state to the second state. For example, a part of the first connection structure 810 between the first connector 814 and the second connector 815 may be at least partially unfolded to compensate for the increased distance according to a relative positional change between the second part 542 and the printed circuit board 570. For example, since the first connection structure 810 is deformable, even when a state of the electronic device 101 is changed, an electrical connection between the printed circuit board 570 and at least one feed point 550 and at least one ground point 560 in the second part 542 may be stably maintained.

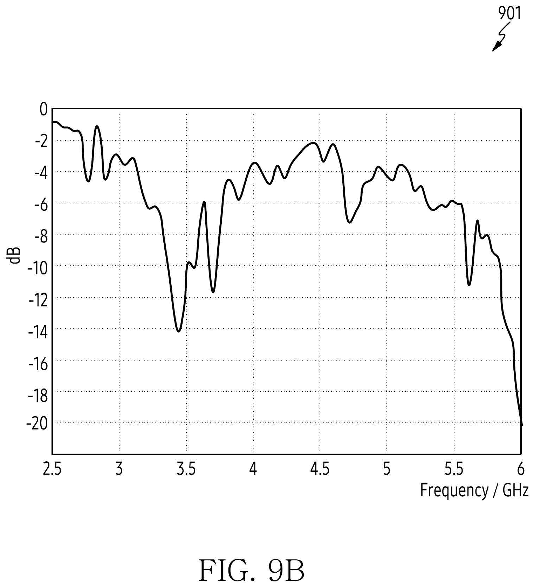

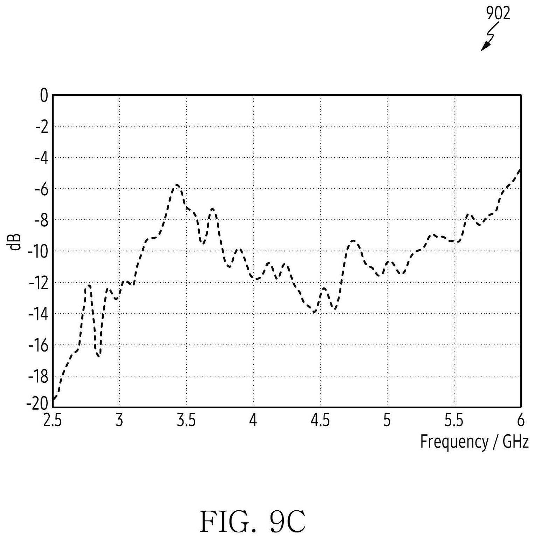

FIG. 9A illustrates a printed circuit board and a connection structure of an electronic device according to an embodiment. FIG. 9B is a graph showing an S-parameter of an antenna of the electronic device illustrated in FIG. 9A. FIG. 9C is a graph showing an efficiency of an antenna of the electronic device illustrated in FIG. 9A.

Referring to FIG. 9A, the electronic device 101 according to an embodiment may include a second connection structure 910 electrically connecting the flexible display 230 and the printed circuit board 570.

For example, in order to control operations of the flexible display 230, an electrical connection between the printed circuit board 570 and the flexible display 230 may be required. The electronic device 101 according to an embodiment may include a processor 120 and a display driver integrated circuit (DDI) 920. For example, the DDI 920 may control the flexible display 230 based on receiving a control signal from the processor 120. For example, the processor 120 may provide a control signal to the DDI 920. For example, the DDI 920 may control an operation of a plurality of pixels based on obtaining a control signal from the processor 120. For example, the DDI 920 may include a Gate IC controlling on/off of sub-pixels included in the plurality of pixels and a Source IC controlling visual information represented by the sub-pixels, but is not limited thereto.

For example, the processor 120 may be disposed on the printed circuit board 570. For example, the DDI 920 may be disposed on the flexible display 230. For example, the flexible display 230 may include a chip on plastic (COP) structure in which the DDI 920 is disposed on a display panel, but is not limited thereto. For example, for an electrical connection between the printed circuit board 570 and the DDI 920, the second connection structure 910 may electrically connect the printed circuit board 570 and the flexible display 230. For example, the second connection structure 910 may include a first connector coupled to the printed circuit board 570 and a second connector coupled to the flexible display 230. For example, a control signal provided from the processor 120 to the DDI 920 may be transmitted from the printed circuit board 570 to the DDI 920 disposed on the flexible display 230 through a control signal line in the second connection structure 910. For example, the control signal line may be included in a ground area 912 of the second connection structure 910. For example, the second connection structure 910 may include a flexible printed circuit board, but is not limited thereto.

For example, the second connection structure 910 connecting the printed circuit board 570 and the flexible display 230 may include a fill cut area 911 in which a conductive layer is removed. For example, at least one feed point 550 (e.g., the first feed point 551) may be positioned within the fill cut area 911. For example, a ground area 912 of the second connection structure 910 may provide a ground for an antenna. For example, as the wireless communication circuitry 192 feeds the first feed point 551, a part 910a of the second connection structure 910 and at least a portion of the second part 542 may operate as an antenna radiator. For example, the part 910a of the second connection structure 910 may be electrically distinguished from another part of the connection structure 910 by the first feed point 551 and the ground area 912 of the second connection structure 910. A matching circuit 930 for impedance matching of a feed signal provided from the wireless communication circuitry 192 to a first feed point 511 may be electrically connected between the wireless communication circuitry 192 and at least one feed point 550.

For example, the second connection structure 910 for electrically connecting the printed circuit board 570 and the flexible display 230 may be configured to provide an RF signal path of an antenna including at least a portion of the second part 542 and the part 910a of the second connection structure 910.

The electronic device 101 according to an embodiment may use the second connection structure 910 electrically connecting the printed circuit board 570 and the flexible display 230 as a connection structure for transmission of an RF signal. For example, the electronic device 101 may use the second connection structure 910 provided for control of the flexible display 230 without including a separate connection structure for electrically connecting the wireless communication circuitry 192 and an antenna including at least a portion of the second part 542 and the part 910a of the second connection structure 910. The electronic device 101 according to an embodiment may secure a space inside the housing 201 and may reduce a manufacturing cost.

Referring to FIG. 9B, when a printed circuit board (e.g., the printed circuit board 570 of FIG. 9A) is electrically connected to a first feed point (e.g., the first feed point 551 of FIG. 9A) through the second connection structure (e.g., the second connection structure 910 of FIG. 9A), an antenna including at least a portion of the second part (e.g., the second part 542 of FIG. 9A) and the part (e.g., the part 910a of FIG. 9A) of the second connection structure 910 may have a low reflection coefficient with respect to a frequency on about 3.5 GHz. For example, the x-axis of a graph 901 of FIG. 9B is a frequency (unit: GHz), and the y-axis of the graph is a reflection coefficient (unit: dB).

Referring to the graph 901, the antenna may have a relatively low reflection coefficient with respect to a frequency on about 3.5 GHz. For example, the antenna may indicate a reflection coefficient of about -14 dB with respect to a frequency on about 3.5 GHz. For example, as power not radiated and reflected is reduced with respect to a frequency on about 3.5 GHz, the antenna may operate as an antenna for transmitting and/or receiving a frequency on about 3.5 GHz.

Referring to FIG. 9C, an antenna including at least a portion of the second part (e.g., the second part 542 of FIG. 9A) and the part (e.g., the part 910a of FIG. 9A) of the second connection structure (e.g., the second connection structure 910 of FIG. 9A) may have a high gain with respect to a frequency on about 3.5 GHz. For example, the x-axis of a graph 902 of FIG. 9C is a frequency (unit: GHz), and the y-axis of the graph is an efficiency (unit: dB).

Referring to the graph 902, the antenna may have a relatively high efficiency with respect to a frequency on about 3.5 GHz. For example, the antenna may indicate an efficiency of about -6 dB with respect to a frequency on about 3.5 GHz. For example, since the antenna has a relatively high efficiency with respect to a frequency on about 3.5 GHz, it may operate as an antenna for transmitting and/or receiving a frequency on about 3.5 GHz.

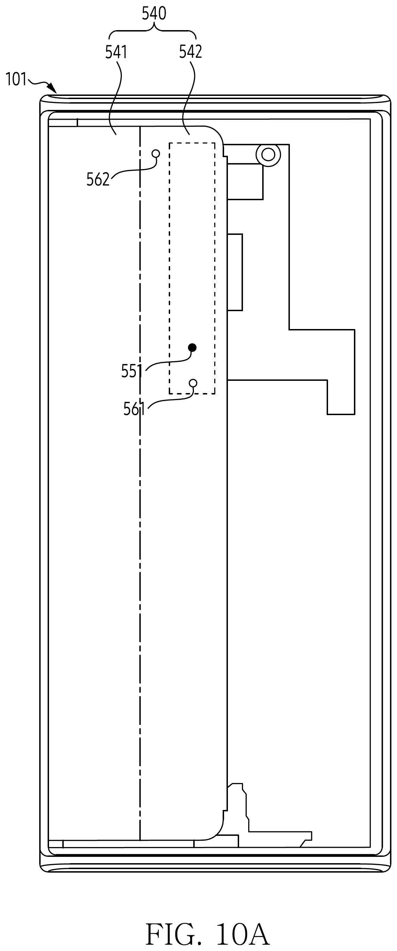

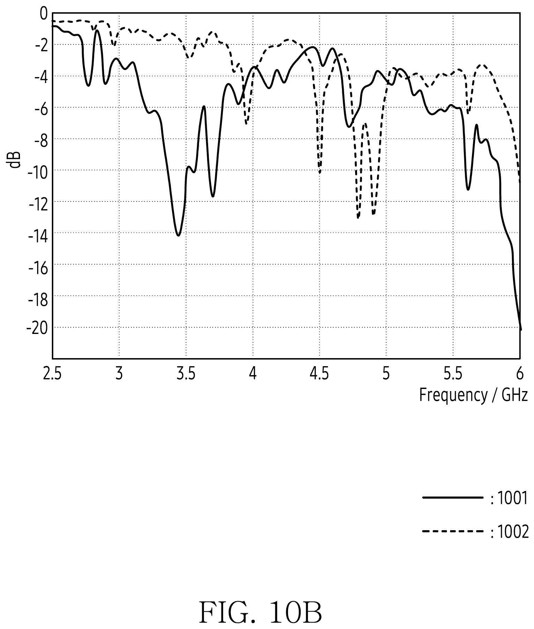

FIG. 10A illustrates a rear surface of an exemplary electronic device. FIG. 10B is a graph for comparing a reflection coefficient of an antenna of the electronic device illustrated in FIG. 9A and a reflection coefficient of an antenna of the electronic device illustrated in FIG. 10A.

Referring to FIG. 10A, the electronic device 101 according to an embodiment may include a first feed point 551, a first ground point 561, and a second ground point 562 positioned in the second part 542. When comparing the electronic device 101 illustrated in FIG. 9A and the electronic device 101 illustrated in FIG. 10A, an area of at least a portion of the second part 542 used as an antenna radiator may be different. For example, by the second ground point 562, an area of the antenna radiator of the electronic device 101 illustrated in FIG. 10A may be smaller than an area of the antenna radiator of the electronic device 101 illustrated in FIG. 9A. The electronic device 101 illustrated in FIG. 10A may be substantially identical to the electronic device 101 illustrated in FIG. 9A except that the electronic device 101 illustrated in FIG. 10A further includes the second ground point 562.

The electronic device 101 according to an embodiment may include a conductive connection member for electrically connecting the second ground point 562 to a ground of the electronic device 101. For example, the conductive connection member may be in contact with the second ground point 562 and the ground of the electronic device 101. For example, the conductive connection member may include a c-clip, a conductive poron, and/or a conductive pin for electrically connecting the second ground point 562 to the ground, but is not limited thereto. For example, as the second ground point 562 is electrically connected to the ground through the conductive connection member, an area of at least a portion of the second part 542 used as an antenna radiator may be reduced compared to a case in which the second ground point 562 is not included. For example, as the area of the antenna radiator is reduced, a frequency characteristic (e.g., a resonance frequency) of an antenna including at least a portion of the second part 542 may be changed.

Referring to FIG. 10B, a change in a frequency characteristic of an antenna including at least a portion of the second part 542 may be identified by the second ground point 562. A first graph 1001 of FIG. 10B indicates a reflection coefficient of the antenna of the electronic device 101 illustrated in FIG. 9A. A second graph 1002 of FIG. 10B indicates a reflection coefficient of the antenna of the electronic device 101 illustrated in FIG. 10A. The x-axis is a frequency (unit: GHz), and the y-axis of the graph is a reflection coefficient (unit: dB).

When comparing the first graph 1001 and the second graph 1002, a resonance frequency indicated by the first graph 1001 may be a frequency on about 3.5 GHz, and a resonance frequency indicated by the second graph 1002 may be a frequency on about 4.5 GHz to about 5 GHz. For example, the resonance frequency indicated by the second graph 1002 may be high shifted from the resonance frequency indicated by the first graph 1001. For example, as an area of the second part 542 used as an antenna radiator is reduced by the second ground point 562, a resonance frequency may be increased. The electronic device 101 according to an embodiment may adjust a frequency characteristic of an antenna including at least a portion of the second part 542 through the second ground point 562. For example, the second ground point 562 may be selectively provided according to a targeted frequency of a signal to be transmitted and/or received through the antenna.

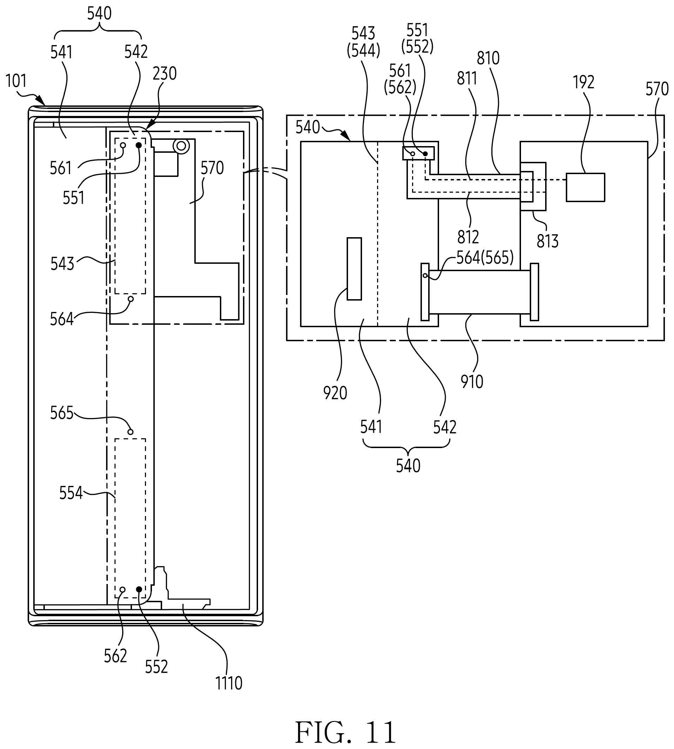

FIG. 11 illustrates a printed circuit board and a connection structure of an electronic device according to an embodiment.

Referring to FIG. 11, the electronic device 101 according to an embodiment may include a plurality of connection structures. For example, the plurality of connection structures may include the first connection structure 810 and the second connection structure 910.

For example, the second part 542 may include a third part 543 and a fourth part 544. For example, the third part 543 may include a first feed point 551 and a first ground point 561. For example, the fourth part 544 may include a second feed point 552 and a second ground point 562. For example, a fourth ground point 564 and a fifth ground point 565 may be positioned between the third part 543 and the fourth part 544. The structure may be referred to as the description described above with reference to FIG. 7A.

For example, the first connection structure 810 may be referred to as the first connection structure 810 illustrated in FIG. 8A. For example, the first connection structure 810 may include a first wiring 811 and a second wiring 812. For example, the first wiring 811 may electrically connect the wireless communication circuitry 192 disposed on the printed circuit board 570 to the first feed point 551 (or the second feed point 552). For example, the second wiring 812 may electrically connect a ground layer of the printed circuit board 570 to the first ground point 561 (and/or the second ground point 562). For example, the first connection structure 810 may include a fill cut area 813. For convenience of description, FIG. 11 illustrates a structure in which the first connection structure 810 is electrically connected to the third part 543, but the first connection structure 810 may also be electrically connected to the fourth part 544. For example, the first connection structure 810 may also be plural. However, it is not limited thereto. For example, the electronic device 101 may further include a third connection structure 1110. For example, the third connection structure 1110 may electrically connect the wireless communication circuitry 192 to the second feed point 552. For example, the third connection structure 1110 may electrically connect a ground layer of the printed circuit board 570 or a ground of the electronic device 101 to the second ground point 562.

For example, the second connection structure 910 may be referred to as the second connection structure 910 illustrated in FIG. 9A. For example, the second connection structure 910 may electrically connect the printed circuit board 570 to the flexible display 230. For example, the second connection structure 910 may electrically connect the fourth ground point 564 and/or the fifth ground point 565 to the ground layer of the printed circuit board 570. For example, the second connection structure 910 may be used for transmission of a control signal provided from the processor 120 disposed on the printed circuit board 570 to the DDI 920 disposed on the flexible display 230. For example, since the wireless communication circuitry 192 is not disposed on the second connection structure 910, the second connection structure 910 may not include a fill cut area (e.g., the fill cut area 911 of FIG. 9A).

For example, an antenna (e.g., a first antenna) including at least a portion of the third part 543 and/or an antenna (e.g., a second antenna) including at least a portion of the fourth part 544 may be electrically connected to the wireless communication circuitry 192 and a ground through the first connection structure 810. For example, wireless communication circuitry (e.g., the wireless communication circuitry 192 of FIG. 5D) may provide an RF signal to the first feed point 551 and/or the second feed point 552 through the first connection structure 810. For example, the wireless communication circuitry 192 may provide an RF signal to the second feed point 552 through the third connection structure 1110. For example, an RF signal provided from an RF transceiver (e.g., the RF transceiver 583 of FIG. 5D) may be provided to the first feed point 551 and/or the second feed point 552 through the first wiring 811 and may be radiated to the outside through at least a portion of the third part 543 and/or at least a portion of the fourth part 544.

For example, the fourth ground point 564 and/or the fifth ground point 565 may electrically distinguish the third part 543 and the fourth part 544 by being electrically connected to the ground layer of the printed circuit board 570 through the second connection structure 910. For example, an electromagnetic field formed as an RF signal is provided to the first feed point 551 may be substantially formed in at least a portion of the third part 543 by the fourth ground point 564. For example, an electromagnetic field formed as an RF signal is provided to the second feed point 552 may be substantially formed in at least a portion of the fourth part 544 by the fifth ground point 565. For example, the fifth ground point 565 may be electrically connected to the ground of the electronic device 101 or the ground layer of the printed circuit board 570 through the third connection structure 1110.

The electronic device 101 according to an embodiment may be configured to communicate with an external electronic device through the first antenna and the second antenna by using the first connection structure 810 and the second connection structure 910. In the above description, it has been described that the first antenna and the second antenna are implemented through the second part 542 of the conductive sheet 540, but are not limited thereto. For example, as the second part 542 is distinguished into two or more parts, two or more antennas may be implemented. The electronic device 101 according to an embodiment may solve shortage of an arrangement space of an antenna by using the second part 542 positioned within the non-active area 520 as an antenna radiator.

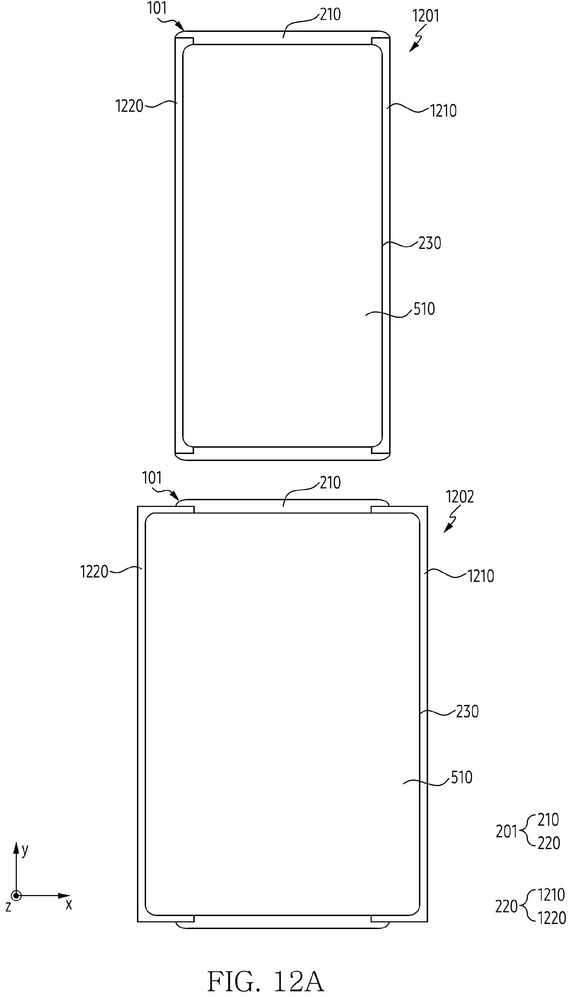

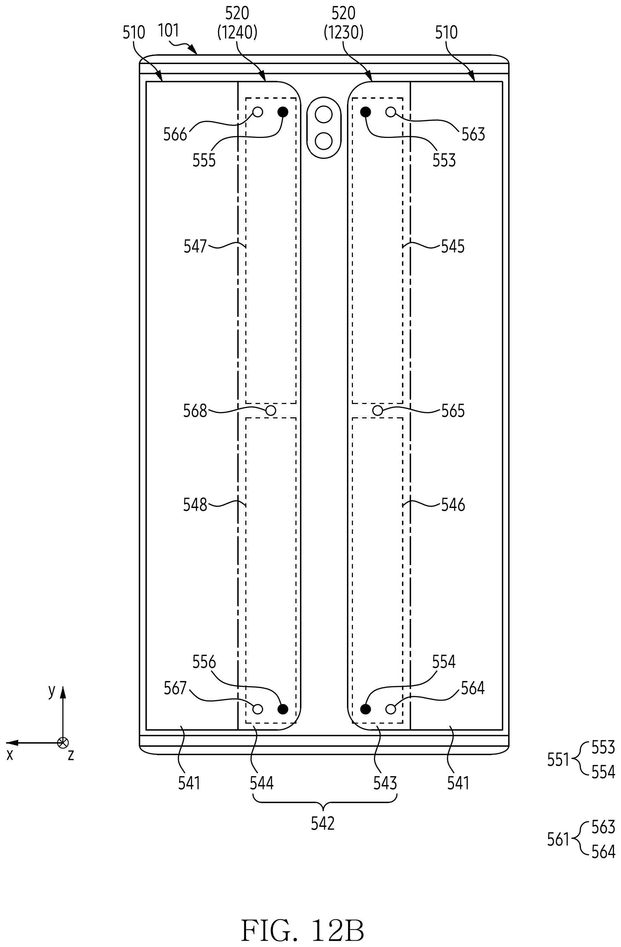

FIG. 12A illustrates a front surface of an electronic device according to an embodiment. FIG. 12B illustrates a rear surface of an electronic device according to an embodiment.

The above-described electronic device 101 has been described that the second housing part 220 is movably connected to the first housing part 210 in a direction, but is not limited thereto. Referring to FIG. 12A and FIG. 12B, the second housing part 220 may be movably connected to the first housing part 210 in a direction and in another direction opposite to the direction.

For example, the second housing part 220 may be movably connected to the first housing part 210 in a direction and in another direction. For example, the second housing part 220 may include a first part 1210 movably connected to the first housing part 210 in a direction (e.g., the +x direction) and a second part 1220 movably connected to the first housing part 210 in another direction (e.g., the -x direction). For example, the first part 1210 and the second part 1220 may be structures separated from each other or may be a structure integrally formed.

For example, 1201 of FIG. 12A indicates the first state. For example, in the first state, at least a portion of the second housing part 220 may be positioned within the first housing part 210. For example, in the first state, a size of the active area 510 of the flexible display 230 positioned outside the housing 201 may be minimum.

For example, 1202 of FIG. 12A indicates the second state. For example, at least a portion of the second housing part 220, which was positioned within the first housing part 210 in the first state, may be moved to the outside of the housing 201 as the electronic device 101 is changed from the first state to the second state. For example, when the electronic device 101 is changed from the first state to the second state, the first part 1210 may be moved in the direction from the first housing part 210, and the second part 1220 may be moved in the another direction from the first housing part 210. For example, in the second state, a size of the active area 510 of the flexible display 230 positioned outside the housing 201 may be maximum.

Referring to FIG. 12B, the non-active area 520 may include two areas spaced apart from each other with the active area 510 therebetween. For example, the non-active area 520 may include a first area 1230 extending from a side (e.g., a side in the +x direction) of the active area 510 and a second area 1240 extending from another side (e.g., a side in the -x direction) of the active area 510. The electronic device 101 illustrated in FIG. 12B may be referred to as the first state. In the first state, the first area 1230 may be spaced apart from the second area 1240.

The above-described descriptions in which at least a portion of the second part 542 is used for communication with an external electronic device may be substantially equally applied to the electronic device 101 illustrated in FIG. 12A.

For example, the conductive sheet 540 may include the first part 541 positioned within the active area 510 and the second part 542 positioned within the non-active area 520. For example, the second part 542 may include the third part 543 and the fourth part 544. For example, the third part 543 may be positioned at a side (e.g., a side in the +x direction) of the first part 541. For example, the fourth part 544 may be positioned at another side (e.g., a side in the -x direction) of the first part 541 opposite to the side. For example, in the first state, the third part 543 may be spaced apart from the fourth part 544.

For example, wireless communication circuitry (e.g., the wireless communication circuitry 192 of FIG. 5D) may be configured to communicate with an external electronic device by using the third part 543 and/or the fourth part 544. For example, the third part 543 may include at least one first feed point 551 and at least one first ground point 561. For example, at least a portion of the third part 543 may operate as an antenna radiator by being fed from the wireless communication circuitry 192. For example, the fourth part 544 may include at least one second feed point 552 and at least one second ground point 562. For example, at least a portion of the fourth part 544 may operate as an antenna radiator by being fed from the wireless communication circuitry 192.

For example, the third part 543 and the fourth part 544 may include a plurality of parts electrically distinguished from each other. For example, the third part 543 may include a fifth part 545 including a third feed point 553 and a third ground point 563 and a sixth part 546 including a fourth feed point 554 and a fourth ground point 564. At least one fifth ground point 565 may be positioned between the fifth part 545 and the sixth part 546. The fifth part 545 and the sixth part 546 may be electrically distinguished by the at least one fifth ground point 565. For example, the fourth part 544 may include a seventh part 547 including a fifth feed point 555 and a sixth ground point 566 and an eighth part 548 including a sixth feed point 556 and a seventh ground point 567. At least one eighth ground point 568 may be positioned between the seventh part 547 and the eighth part 548. The seventh part 547 and the eighth part 548 may be electrically distinguished by the at least one eighth ground point 568.

For example, the wireless communication circuitry 192 may be configured to communicate with an external electronic device by using the fifth part 545, the sixth part 546, the seventh part 547, and/or the eighth part 548. For example, when the wireless communication circuitry 192 transmits a signal to an external electronic device by using an antenna including at least a portion of the fifth part 545, the wireless communication circuitry 192 may provide an RF signal to the third feed point 553 positioned within the fifth part 545. The RF signal may be radiated to the outside through at least a portion of the fifth part 545. The electronic device 101 according to an embodiment may improve utilization of a limited inner space of the housing 201 by using the second part 542 positioned within the housing 201 as an antenna radiator.

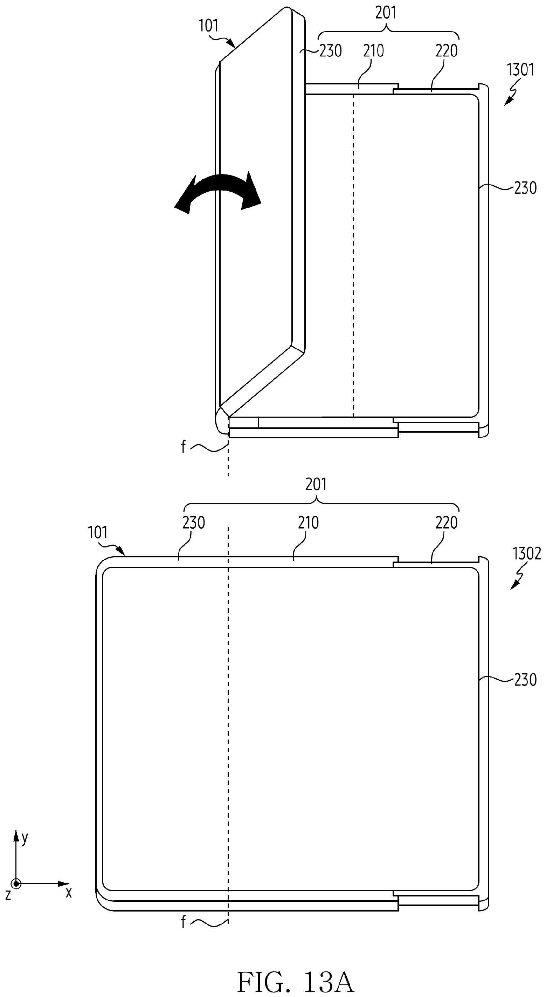

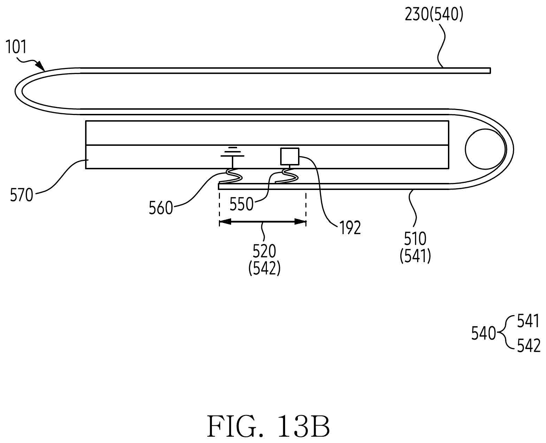

FIG. 13A illustrates an electronic device according to an embodiment. FIG. 13B schematically illustrates a flexible display and a printed circuit board of the electronic device illustrated in FIG. 13A.

For example, the housing 201 may include a first housing part 210, a second housing part 220, and a third housing part 1310. 1301 of FIG. 13A illustrates the third housing part 1310 being rotated with respect to the first housing part 210 based on a folding axis f. 1302 of FIG. 13B illustrates a state in which the third housing part 1310 is disposed substantially on the same plane as the first housing part 210.

For example, the first housing part 210 may be disposed between the second housing part 220 and the third housing part 1310. For example, the second housing part 220 may be slidably connected to a side (e.g., a side in the +x direction) of the first housing part 210. For example, the third housing part 1310 may be rotatably connected to another side (e.g., a side in the -x direction) of the first housing part 210 opposite to the side. The electronic device 101 according to an embodiment may include a hinge portion disposed between the first housing part 210 and the third housing part 1310 and rotatably connecting the third housing part 1310 to the first housing part 210. By the hinge portion, the third housing part 1310 may be rotatable with respect to the first housing part 210 based on the folding axis f. The electronic device 101 according to an embodiment may be in a folded state in which the third housing part 1310 is stacked above the first housing part 210 (e.g., in a +z direction), an unfolded state in which the third housing part 1310 is disposed substantially on the same plane as the first housing part 210, and a plurality of intermediate states between the folded state and the unfolded state. For example, the flexible display 230 may be disposed on the first housing part 210, the second housing part 220, and the third housing part 1310.

Referring to FIG. 13B, the flexible display 230 may include a non-active area 520 positioned within the housing 201 independently of movement of a second housing part (e.g., the second housing part 220 of FIG. 13A).

The above-described descriptions in which at least a portion of the second part 542 is used for communication with an external electronic device may be substantially equally applied to the electronic device 101 illustrated in FIG. 13A.

For example, the second part 542 may include at least one feed point 550 and at least one ground point 560. For example, the at least one feed point 550 and the at least one ground point 560 may be electrically connected to the printed circuit board 570 through a connection structure (e.g., the first connection structure 810 or the second connection structure 910). For example, the at least one feed point 550 may be electrically connected to the wireless communication circuitry 192 disposed on the printed circuit board 570. For example, the at least one ground point 560 may be electrically connected to a ground layer of the printed circuit board 570 electrically connected to a ground of the electronic device 101. For example, at least a portion of the second part 542 may operate as an antenna radiator by being fed from the wireless communication circuitry 192.

An electronic device 101 is provided. The electronic device 101 may include wireless communication circuitry 192, a housing 201, and a flexible display 230. The housing 201 may include a first housing part 210 and a second housing part 220 movably coupled to the first housing part 210. The flexible display may include an active area 510 configured to display visual information and a non-active area 520 positioned within the housing 201 independently of movement of the second housing part 220. The flexible display 230 may include a plurality of layers 530 including a conductive sheet 540. The conductive sheet 540 may include a first part 541 positioned within the active area 510 and a second part 542 positioned within the non-active area 520. The second part 542 may include at least one feed point 550 electrically connected to the wireless communication circuitry 192 and at least one ground point 560 electrically connected to a ground of the electronic device 101. The wireless communication circuitry 192 may be configured to communicate with an external electronic device by using at least a portion of the second part 542.

For example, the conductive sheet 540 may include at least one of an electro static discharge (ESD) sheet, a support sheet for supporting the flexible display 230, or a shielding sheet for shielding noise.

For example, a shape of the second part 542 may correspond to a shape of the non-active area 520. When the non-active area 520 maintains a substantially flat shape, the second part 542 may maintain a substantially flat shape independently of movement of the second housing part 220. When the non-active area 520 is partially bent, the second part 542 may be partially bent.

For example, the second part 542 may include a third part 543 including a first feed point 551 and a first ground point 561, wherein at least a portion of the third part 543 is configured to transmit or receive a signal on a first frequency, a fourth part 544 including a second feed point 552 and a second ground point 562, wherein at least a portion of the fourth part 544 is configured to transmit or receive a signal on a second frequency, and at least one third ground point 563 positioned between the third part 543 and the fourth part 544. The wireless communication circuitry 192 may be configured to communicate with the external electronic device by using at least one of at least a portion of the third part 543 or at least a portion of the fourth part 544 distinguished by the at least one third ground point 563.

For example, the at least one third ground point 563 may include a fourth ground point 564 closer to the third part 543 among the third part 543 and the fourth part 544 and a fifth ground point 565 closer to the fourth part 544 among the third part 543 and the fourth part 544. The first frequency may be based on an electrical length L1 of the third part 543 based on a location of the fourth ground point 564. The second frequency may be based on an electrical length L2 of the fourth part 544 based on a location of the fifth ground point 565.

For example, the electronic device 101 may further include a printed circuit board 570 on which the wireless communication circuitry 192 is disposed and a first connection structure 810 electrically connecting the printed circuit board 570 to the at least one feed point 550 and the at least one ground point 560.

For example, the first connection structure 810 may include a first wiring 811 electrically connecting the wireless communication circuitry 192 and the at least one feed point 550 and a second wiring 812 electrically connecting a ground layer of the printed circuit board 570 and the at least one ground point 560.

For example, the first connection structure 810 may be deformable between the conductive sheet 540 and the printed circuit board 570 based on movement of the second housing part 220.

For example, the electronic device 101 may further include the printed circuit board 570 on which the processor 120 is disposed and a second connection structure 910 on which the wireless communication circuitry 192 is disposed and electrically connecting the flexible display 230 and the printed circuit board 570. For example, the processor 120 may be configured to control the flexible display 230, but is not limited thereto. The second connection structure 910 may electrically connect the wireless communication circuitry 192 to the at least one feed point 550 and may electrically connect a ground layer of the printed circuit board 570 to the first ground point 561 positioned within the second part 542.

For example, the second part 542 may further include a second ground point 562. The electronic device 101 may further include a conductive connection member electrically connecting the second ground point 562 to the ground.

For example, the second part 542 may include a third part 543 including a first feed point 551 and a first ground point 561 and configured to transmit or receive a signal on a first frequency band, a fourth part 544 including a second feed point 552 and a second ground point 562 and configured to transmit or receive a signal on a second frequency band, and at least one third ground point 563 positioned between the third part 543 and the fourth part 544. The electronic device 101 may further include a printed circuit board 570 on which the wireless communication circuitry 192 is disposed, a first connection structure 810 electrically connecting the printed circuit board 570 to the first feed point 551, the first ground point 561, the second feed point 552, and the second ground point 562, and a second connection structure 910 electrically connecting the flexible display 230 and the printed circuit board 570 and electrically connecting the at least one third ground point 563 to the ground.

For example, the conductive sheet 540 may be positioned at an outermost location among the plurality of layers 530 by forming a rear surface of the flexible display 230.

For example, the second part 542 may include a third part 543 positioned at a side of the first part 541 and including at least one first feed point 551 and at least one first ground point 561 and a fourth part 544 positioned at another side of the first part 541 opposite to the side and including at least one second feed point 552 and at least one second ground point 562. The third part 543 may be spaced apart from the fourth part 544 in a state in which the second housing part 220 is inserted into the first housing part 210. The wireless communication circuitry 192 may be configured to communicate with the external electronic device by using at least one of the third part 543 or the fourth part 544.

For example, the third part 543 may include a fifth part 545 including a third feed point 553 and a third ground point 563, a sixth part 546 including a fourth feed point 554 and a fourth ground point 564, and at least one fifth ground point 565 positioned between the fifth part 545 and the sixth part 546. The fourth part 544 may include a seventh part 547 including a fifth feed point 555 and a sixth ground point 566, an eighth part 548 including a sixth feed point 556 and a seventh ground point 567, and at least one eighth ground point 568 positioned between the seventh part 547 and the eighth part 548. The wireless communication circuitry 192 may be configured to communicate with the external electronic device by using at least one of the fifth part 545, the sixth part 546, the seventh part 547, or the eighth part 548.

For example, the second housing part 220 may be movably coupled to a side of the first housing part 210. The housing 201 may further include a third housing part 1310 rotatably coupled to another side of the first housing part 210 opposite to the side.

An electronic device 101 is provided. The electronic device 101 may include wireless communication circuitry 192, a housing 201, a flexible display 230, and a conductive sheet 540. The housing 201 may include a first housing part 210 and a second housing part 220 movably (or slidably) coupled to the first housing part 210. The flexible display 230 may include an active area 510 configured to display visual information and a non-active area 520 positioned within the housing 201 independently of movement of the second housing part 220. The flexible display 230 may include a conductive sheet 540 including at least one of an electro static discharge (ESD) sheet, a support sheet, or a shielding sheet for shielding noise. The conductive sheet 540 may include a first part 541 positioned within the active area 510 and a second part 542 positioned within the non-active area 520. The second part 542 may include at least one ground point 560 electrically connected to a ground of the electronic device 101 and at least one feed point 550 positioned closer to an end of the second part 542 spaced apart from the first part 541 and electrically connected to the wireless communication circuitry 192. The wireless communication circuitry 192 may be configured to communicate with an external electronic device by using at least a portion of the second part 542.

For example, a shape of the second part 542 may correspond to a shape of the non-active area 520.

For example, the second part 542 may include a third part 543 including a first feed point 551 and a first ground point 561, wherein at least a portion of the third part 543 is configured to transmit or receive a signal on a first frequency, a fourth part 544 including a second feed point 552 and a second ground point 562, wherein at least a portion of the fourth part 544 is configured to transmit or receive a signal on a second frequency, and at least one third ground point 563 positioned between the third part 543 and the fourth part 544. The wireless communication circuitry 192 may be configured to communicate with the external electronic device by using at least one of at least a portion of the third part 543 or at least a portion of the fourth part 544 distinguished by the at least one third ground point 563.

For example, the at least one third ground point 563 may include a fourth ground point 564 closer to the third part 543 among the third part 543 and the fourth part 544 and a fifth ground point 565 closer to the fourth part 544 among the third part 543 and the fourth part 544.

For example, the electronic device 101 may further include a printed circuit board 570 on which the wireless communication circuitry 192 is disposed and a connection structure electrically connecting the printed circuit board 570 to the at least one feed point 550 and the at least one ground point 560.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
wireless communication circuitry;
a housing including a first housing part and a second housing part movably coupled to the first housing part; and
a flexible display including an active area configured to display visual information and a non-active area positioned within the housing independently of movement of the second housing part,
wherein the flexible display includes a plurality of layers comprising a conductive sheet,
wherein the conductive sheet includes a first part positioned within the active area and a second part positioned within the non-active area,
wherein the second part includes at least one feed point electrically connected to the wireless communication circuitry and at least one ground point electrically connected to a ground of the electronic device, and
wherein the wireless communication circuitry is configured to communicate with an external electronic device using at least a portion of the second part.

2. The electronic device of claim 1,
wherein the conductive sheet includes at least one of an electrostatic discharge (ESD) sheet, a support sheet for supporting the flexible display, or a shielding sheet for shielding noise.

3. The electronic device of any one of claims 1 or 2,
wherein a shape of the second part corresponds to a shape of the non-active area of the flexible display.

4. The electronic device of any one of claims 1 to 3,
wherein the second part includes:
a third part including a first feed point and a first ground point, wherein at least a portion of the third part is configured to transmit or receive a signal on a first frequency,
a fourth part including a second feed point and a second ground point, wherein at least a portion of the fourth part is configured to transmit or receive a signal on a second frequency, and
at least one third ground point positioned between the third part and the fourth part, and
wherein the wireless communication circuitry is configured to communicate with the external electronic device using at least one of at least a portion of the third part or at least a portion of the fourth part distinguished by the at least one third ground point.

5. The electronic device of claim 4,
wherein the at least one third ground point includes:
a fourth ground point closer to the third part of the third part and the fourth part, and
a fifth ground point closer to the fourth part of the third part and the fourth part,
wherein the first frequency is based on an electrical length of the third part based on a location of the fourth ground point, and
wherein the second frequency is based on an electrical length of the fourth part based on a location of the fifth ground point.

6. The electronic device of any one of claims 1 to 5, further comprising:
a printed circuit board on which the wireless communication circuitry is disposed; and
a first connection structure electrically connecting the printed circuit board to the at least one feed point and the at least one ground point.

7. The electronic device of claim 6,
wherein the first connection structure includes:
a first wiring electrically connecting the wireless communication circuitry and the at least one feed point, and
a second wiring electrically connecting a ground layer of the printed circuit board and the at least one ground point.

8. The electronic device of any one of claims 6 or 7,
wherein the first connection structure is deformable based on movement of the second housing part between the conductive sheet and the printed circuit board.

9. The electronic device of any one of claims 1 to 8, further comprising:
a printed circuit board on which a processor is disposed; and
a second connection structure on which the wireless communication circuitry is disposed and electrically connecting the flexible display to the printed circuit board,
wherein the second connection structure electrically connects the wireless communication circuitry to the at least one feed point and a ground layer of the printed circuit board and a first ground point positioned within the second part.

10. The electronic device of claim 9,
wherein the second part further includes a second ground point, and
wherein the electronic device further comprises a conductive connection member that electrically connects the second ground point to the ground.

11. The electronic device of any one of claims 1 to 10,
wherein the second part includes:
a third part including a first feed point and a first ground point, wherein at least a portion of the third part is configured to transmit or receive a signal on a first frequency band,
a fourth part including a second feed point and a second ground point, wherein at least a portion the fourth part is configured to transmit or receive a signal on the a second frequency band, and
at least one third ground point positioned between the third part and the fourth part,
wherein the electronic device further comprises:
a printed circuit board on which the wireless communication circuitry is disposed;
a first connection structure electrically connecting the printed circuit board to the first feed point, the first ground point, the second feed point, and the second ground point; and
a second connection structure electrically connecting the flexible display to the printed circuit board, and electrically connecting the at least one third ground point to the ground.

12. The electronic device of any one of claims 1 to 11,
wherein the conductive sheet is positioned at an outermost location among the plurality of layers by forming a rear surface of the flexible display.

13. The electronic device of any one of claims 1 to 12,
wherein the second part includes:
a third part positioned on a side of the first part and including at least one first feed point and at least one first ground point, and
a fourth part positioned on another side of the first part opposite to the side of the first part and including at least one second feed point and at least one second ground point,
wherein the third part is spaced apart from the fourth part in a state in which the second housing part is inserted into the first housing part, and
wherein the wireless communication circuitry is configured to communicate with the external electronic device using at least one of the third part or the fourth part.

14. The electronic device of claim 13,
wherein the third part includes:
a fifth part including a third feed point and a third ground point,
a sixth part including a fourth feed point and a fourth ground point, and
at least one fifth ground point positioned between the fifth part and the sixth part,
wherein the fourth part includes:
a seventh part including a fifth feed point and a sixth ground point,
an eighth part including a sixth feed point and a seventh ground point, and
at least one eighth ground point positioned between the seventh part and the eighth part, and
wherein the wireless communication circuitry is configured to communicate with the external electronic device using at least one of the fifth part, the sixth part, the seventh part, or the eighth part.

15. The electronic device of any one of claims 1 to 14,
wherein the second housing part is movably coupled to a side of the first housing part, and
wherein the housing further includes a third housing part rotatably coupled to another side of the first housing part opposite to the side.
